# EUROPÄISCHE PATENTSCHRIFT

(11) **EP 1 522 129 B1**
(45) Veröffentlichungstag und Bekanntmachung des Hinweises auf die Patenterteilung: **11.03.2015**
(21) Anmeldenummer: 03732419.1
(22) Anmeldetag: 20.05.2003
(51) Int. Cl.: B82Y 20/00, H01S 3/094, H01S 3/0941, H01S 3/23, H01S 5/024, H01S 5/04, H01S 5/183, H01S 5/34, H01S 5/14, H01S 5/42

(54) **Optisch gepumpter Halbleiterlaser**
Optically pumped semiconductor laser system
Système laser pompé optiquement

(30) Priorität: 29.05.2002 DE 10223879
(43) Veröffentlichungstag der Anmeldung: 13.04.2005
(73) Patentinhaber: OSRAM Opto Semiconductors GmbH, 93055 Regensburg (DE)
(72) Erfinder: GIESEN, Adolf, 71272 Renningen (DE); BEYERTT, Svent-Simon, 73730 Esslingen (DE); BRAUCH, Uwe, 70565 Stuttgart (DE)
(74) Vertreter: Epping - Hermann - Fischer
(86) Internationale Anmeldenummer: PCT/EP2003/005270
(87) Internationale Veröffentlichungsnummer: WO 2003/100922

(56) Entgegenhaltungen:
- US-A- 5 131 002
- US-A- 5 313 324
- US-A1- 2001 043 636
- JEONG K T ET AL: "Analysis and assessment of the gain of optically pumped surface-normal optical amplifiers" OPTICS COMMUNICATIONS, NORTH-HOLLAND PUBLISHING CO. AMSTERDAM, NL, Bd. 135, Nr. 4, 15. Februar 1997 (1997-02-15), Seiten 227-232, XP004016507 ISSN: 0030-4018
- W. BLUDAU: "Halbleiter-Optoelektronik" 1995 , HANSER VERLAG MÜNCHEN WIEN , GERSTHOFEN XP002271555 Seite 182 -Seite 185
- J. BOHN ET AL.: "Resonant optical pumping of vertical-cavity surface emitting lasers", OPTICS COMMUNICATIONS, vol. 117, no. 1, 1995, pages 111-115, XP004011655, NORTH-HOLLAND PUB. CO. AMSTERDAM

## Beschreibung

Die Erfindung betrifft ein Laserverstärkersystem umfassend einen mit einem Kühlkörper thermisch gekoppelten Festkörper mit einem laseraktiven Volumenbereich, in welchem in mindestens einer Fläche mindestens eine sich zumindest über Teilbereiche der Fläche erstreckende laseraktive Verstärkerstruktur aus Halbleitermaterial angeordnet ist, eine ein Pumpstrahlungsfeld erzeugende Pumpstrahlungsquelle zum optischen Pumpen des laseraktiven Volumenbereichs und eine ein den laseraktiven Volumenbereich durchsetzendes Laserverstärkerstrahlungsfeld definierende Verstärkeroptik.

Derartige Laserverstärkersysteme sind aus dem Stand der Technik bekannt.

US Patent Application US 2001 0043636 offenbart ein solches Laserverstärkersystem.

Ausgehend von derartigen Laserverstärkersystemen liegt der Erfindung die Aufgabe zugrunde, die Laserverstärkersysteme möglichst effizient zu betreiben.

Diese Aufgabe wird von einem Laserverstärkersystem wie in Anspruch 1 definiert gelöst. Die Absorption von Pumpstrahlung aus dem Pumpstrahlungsfeld in der laseraktiven Verstärkerstruktur ist größer als die Absorption von Pumpstrahlung durch eine an die Verstärkerstruktur angrenzende Umgebungsstruktur und das Pumpstrahlungsfeld verläuft so, daß es die Verstärkerstruktur mehrfach durchsetzt.

Der Vorteil der erfindungsgemäßen Lösung ist darin zu sehen, daß bei dieser die Pumpstrahlung überwiegend in der Verstärkerstruktur selbst absorbiert wird und somit Verluste beim Wandern von Löchern und Elektronen in die Verstärkerstruktur reduziert werden können.

Ferner wird ein effizientes Pumpen der Verstärkerstruktur dadurch erreicht, daß das Pumpstrahlungsfeld die Verstärkerstruktur mehrfach durchsetzt.

Besonders vorteilhaft ist es dabei, wenn die Absorption von Pumpstrahlung in der mindestens einen Verstärkerstruktur die Absorption von Pumpstrahlung in der an die Verstärkerstruktur angrenzenden Umgebungsstruktur überwiegt.

Noch besser ist es, wenn die Absorption von Pumpstrahlung in der Umgebungsstruktur gegenüber der Absorption von Pumpstrahlung in der Verstärkerstruktur vernachlässigbar ist, so daß im wesentlichen die Verstärkerstruktur unmittelbar durch die Pumpstrahlung gepumpt wird.

Insbesondere um eine unnötige Erwärmung des Festkörpers zu vermeiden ist es besonders vorteilhaft, wenn die Absorption von Pumpstrahlung in der mindestens einen Verstärkerstruktur die Absorption von Pumpstrahlung in den übrigen Volumenbereichen des Festkörpers außerhalb der Verstärkerstruktur überwiegt.

Hinsichtlich der Ausbildung des laseraktiven Volumenbereichs wurden im Zusammenhang mit der bisherigen Erläuterung der erfindungsgemäßen Lösung keine näheren Angaben gemacht. So ist es prinzipiell zunächst ausreichend, eine Verstärkerstruktur, die sich in einer dieser zugeordneten Fläche erstreckt, vorzusehen.

Die Verstärkung des Laserverstärkerstrahlungsfeldes kann jedoch noch dadurch verbessert werden, daß der laseraktive Volumenbereich mehrere, in einer Stapelrichtung im Abstand voneinander, jedoch in übereinander angeordneten Flächen liegende Verstärkerstrukturen aufweist. Dadurch kann jede der Verstärkerstrukturen zur Verstärkung des Laserverstärkerstrahlungsfeldes beitragen, wenn dieses die jeweilige Verstärkerstruktur durchsetzt.

Hinsichtlich der Ausbildung der Umgebungsstrukturen wurden bislang keine näheren Angaben gemacht. Prinzipiell könnten die Umgebungsstrukturen, da sie für die unmittelbare Funktion der Verstärkerstruktur nicht maßgebend sind, aus beliebigen Materialien sein, so lange keine Störung der Verstärkerstruktur erfolgt.

Besonders störungsfrei verhalten sich jedoch Umgebungsstrukturen, wenn diese aus einem Halbleitermaterial gebildet sind, wobei vorzugsweise die Umgebungsstruktur, Kristallstruktur und ähnliche Gitterkonstanten, wenn nicht im wesentlichen dieselben dieser Gitterkonstanten wie die Verstärkerstruktur selbst aufweist.

Eine besonders günstige Lösung sieht vor, daß die Umgebungsstruktur durch Schichten aus Halbleitermaterial gebildet ist, da sich damit in einfacher Weise die Umgebungsstrukturen im Anschluß an die Quantenstruktur aufbauen lassen.

Um sicherzustellen, daß die durch das optische Pumpen erzeugten Elektronen und Löcher in der Verstärkerstruktur verbleiben, ist vorzugsweise vorgesehen, daß das Halbleitermaterial der Verstärkerstruktur einen geringeren Bandabstand aufweist als die Umgebungsstruktur.

Unter Bandabstand ist dabei der in der Halbleitertechnik übliche Begriff zu verstehen, nämlich die Energiedifferenz zwischen dem obersten Valenzband und dem untersten Leitungsband.

Eine bevorzugte Einbettung der Verstärkerstruktur in dem Festkörper sieht vor, daß beiderseits der Fläche, in welcher die Verstärkerstruktur angeordnet ist, jeweils mindestens eine Umgebungsstruktur angeordnet ist.

Hinsichtlich der Ausbildung der Umgebungsstruktur selbst wurden bislang keine näheren Angaben gemacht. So sieht eine vorteilhafte Lösung vor, daß jede Umgebungsstruktur quer zu der Fläche eine Dicke aufweist, die ein mehrfaches der Dicke der Verstärkerstruktur beträgt, so daß eine optimale Einbettung und Abschirmung der Verstärkerstruktur gegenüber Einflüssen übriger Bereiche des Festkörpers erreichbar ist.

Beispielsweise ist dabei vorgesehen, daß die Umgebungsstruktur quer zu der Fläche eine Dicke aufweist, die mindestens 10 nm beträgt.

Noch besser ist es, wenn die Umgebungsstruktur quer zu der Fläche eine Dicke aufweist, die mindestens 30 nm beträgt.

Hinsichtlich der Anordnung der Verstärkerstrukturen in dem laseraktiven Volumenbereich wurden im Zusammenhang mit der bisherigen Erläuterung der erfindungsgemäßen Lösung keine weiteren Angaben gemacht. So sieht eine besonders günstige Lösung vor, daß die Verstärkerstrukturen durch zwischen diesen liegende Zwischenschichten voneinander getrennt sind.

Die Zwischenschichten können dabei aus beliebigen Materialien sein.

Vorzugsweise werden derartige Zwischenschichten jeweils im Anschluß an die Verstärkerstruktur angeordnete Umgebungsstrukturen umfassen. Die Zwischenschichten können dabei ausschließlich aus Umgebungsstrukturen aufgebaut sein. Es besteht aber auch die Möglichkeit, zwischen den Umgebungsstrukturen noch Zwischenschichten aus weiteren oder anders gearteten Materialien vorzusehen.

Vorzugsweise sind die Zwischenschichten aus einem derartigen Material, daß die Absorption von Pumpstrahlung aus dem Pumpstrahlungsfeld in den Verstärkerstrukturen gleich oder größer als die Absorption von Pumpstrahlung durch die Zwischenschichten ist.

Vorzugsweise ist die Absorption von Pumpstrahlung durch die Zwischenschichten gegenüber der Absorption von Pumpstrahlung in den Verstärkerstrukturen vernachlässigbar.

Hinsichtlich des Verlaufs des Laserverstärkerstrahlungsfeldes relativ zu den Flächen, in denen die Verstärkerstrukturen angeordnet sind, wurden bislang keine näheren Angaben gemacht.

Eine besonders günstige Verstärkung im Laserverstärkerstrahlungsfeld ist dann erreichbar, wenn das Laserverstärkerstrahlungsfeld quer zu der Fläche verläuft, in welcher sich die Verstärkerstruktur erstreckt.

Vorzugsweise verläuft dabei das Laserverstärkerstrahlungsfeld ungefähr in Richtung der Stapelrichtung der Verstärkerstrukturen.

Bezüglich des Abstandes der Verstärkerstrukturen in Richtung des Verlaufs des Laserverstärkerstrahlungsfeldes wurden bislang keine näheren Angaben gemacht.

So sieht eine besonders günstige Lösung vor, daß bei mindestens einem Teil der Verstärkerstrukturen diese in Richtung des Verlaufs des Laserverstärkerstrahlungsfeldes, vorzugsweise in der Stapelrichtung, Abstände aufweisen, die ungefähr der halben Wellenlänge oder einem ganzzahligen Vielfachen der halben Wellenlänge des Laserverstärkerstrahlungsfeldes bei optimaler Laserverstärkung entsprechen.

Damit besteht die Möglichkeit, daß alle Verstärkerstrukturen in den genannten Abständen in Stapelrichtung angeordnet sind oder daß Verstärkerstrukturen zu Gruppen mit in geringeren Abständen innerhalb jeder Gruppe angeordneten Verstärkerstrukturen zusammengefaßt sind und daß die Gruppen von Verstärkerstrukturen in den genannten Abständen angeordnet sind, so daß auch dann die Verstärkerstrukturen unterschiedlicher Gruppen ebenfalls in den genannten Abständen angeordnet sind.

Liegen derartige Abstände zwischen den Verstärkerstrukturen im Festkörper vor, ohne daß ein optisches Pumpen durch die Pumpstrahlungsquelle eine Laserverstärkung des laseraktiven Volumenbereichs erfolgt, so besteht die Gefahr, daß diese Abstände im Zustand der Laserverstärkung des laseraktiven Volumenbereichs nicht mehr exakt mit der Vorgabe übereinstimmen.

Aus diesem Grund ist vorzugsweise vorgesehen, daß die Abstände der Verstärkerstrukturen im thermodynamischen Gleichgewichtszustand des Festkörpers bei Laserverstärkung des laseraktiven Volumenbereichs dem Vielfachen der halben Wellenlänge der optimalen Laserverstärkung entsprechen.

Hinsichtlich der Ausrichtung der Fläche, in welcher die dieser jeweils zugeordnete Verstärkerstruktur angeordnet ist, wurden bislang keine näheren Angaben gemacht.

Eine zweckmäßige Lösung sieht vor, daß sich die Fläche, in der die Verstärkerstruktur angeordnet ist, ungefähr parallel zu einer äußeren Kühlfläche des Festkörpers erstreckt.

Eine weitere vorteilhafte Lösung sieht vor, daß sich die Fläche in der die Verstärkerstruktur angeordnet ist, ungefähr parallel zu einer Austrittsfläche für das Laserverstärkerstrahlungsfeld erstreckt.

Ungefähr parallel bedeutet dabei, daß die Flächen einen Winkel von bis zu 10° miteinander einschließen können.

Um bei dem erfindungsgemäßen Laserverstärkersystem zu verhindern, daß eine Strahlungsverstärkung auch bei sich in Richtung der Fläche ausbreitender Strahlung oder schräg zu der Fläche ausbreitender Strahlung erfolgt, ist vorzugsweise vorgesehen, daß zwischen der Austrittsfläche für das Laserverstärkerstrahlungsfeld und der Fläche, in der sich die Verstärkerstruktur erstreckt, eine optisch inaktive Schicht mit einer Dicke liegt, die ein mehrfaches der Wellenlänge des Laserverstärkerstrahlungsfeldes beträgt.

Hinsichtlich der Ausbildung der Verstärkerstruktur selbst wurden bislang noch keine näheren Angaben gemacht.

So sieht eine vorteilhafte Lösung vor, daß die Verstärkerstruktur eine Dicke aufweist, die so gering ist, daß durch diese eine Vergrößerung der Zustandsdichte an der Bandkante der Verstärkerstruktur eintritt.

Die Verstärkerstruktur kann in Richtung senkrecht zu der jeweiligen Fläche dicker sein als übliche bei Halbleiterlasern eingesetzte Quantenstrukturen. Eine günstige Lösung sieht jedoch vor, daß die Verstärkerstruktur als Quantenstruktur ausgebildet ist.

Insbesondere liegt dabei die Dicke der Quantenstruktur ungefähr in der Größenordnung der Wellenlänge der Elektronen im Material der Quantenstruktur.

Zweckmäßigerweise sind die Quantenstrukturen so dimensioniert, daß deren Dicke quer zu der Fläche weniger als 20 nm beträgt.

Hinsichtlich der Ausbildung der Quantenstruktur selbst sind die unterschiedlichsten Möglichkeiten denkbar.

So sieht eine Möglichkeit vor, daß die Quantenstruktur als Quantenfilm ausgebildet ist, wobei ein derartiger Quantenfilm näherungsweise ein zweidimensionales Elektronengas umfaßt.

Eine weitere Möglichkeit einer Realisierung der Quantenstruktur ist die, daß diese aus Quantendrähten ausgebildet ist, wobei ein derartiger Quantendraht näherungsweise ein eindimensionales Elektronengas umfaßt.

Eine andere Möglichkeit besteht darin, daß die Quantenstruktur aus Quantenpunkten ausgebildet ist und somit näherungsweise ein nulldimensionales Elektronengas umfaßt.

Hinsichtlich des Verlaufs des Laserverstärkerstrahlungsfeldes in dem Festkörper wurden bislang keine näheren Angaben gemacht. Beispielsweise wäre es denkbar, daß das Laserverstärkerstrahlungsfeld den Festkörper vollständig durchsetzt.

Um jedoch den Festkörper auf einer Seite optimal kühlen zu können, und zwar vorzugsweise so, daß sich ein zumindest über die Ausdehnung des Laserverstärkerstrahlungsfeldes in Richtung der Flächen im wesentlichen gleichmäßiger Temperaturgradient in Richtung der Kühlfläche innerhalb des Festkörpers einstellt, ist vorgesehen, daß der Festkörper auf einer Seite des laseraktiven Volumenbereichs einen Reflektor für das Laserverstärkerstrahlungsfeld aufweist.

Der Reflektor könnte dabei beispielsweise als dielektrische Schicht auf eine Oberfläche des Festkörpers aufgetragen sein.

Besonders vorteilhaft läßt sich jedoch der Festkörper dann kühlen, wenn der Reflektor ein interner Reflektor eines insbesondere monokristallinen Schichten aufweisenden Festkörpers ist, da damit die nachteilige Isolationswirkung einer auf den Festkörper aufgetragenen, insbesondere im Bereich der Kühlfläche aufgetragenen dielektrischen, insbesondere polykristallinen oder amorphen Schicht vermieden werden kann.

Vorzugsweise ist dabei vorgesehen, daß der interne Reflektor durch eine Folge von Schichten im Festkörper gebildet ist.

Eine besonders günstige Lösung sieht dabei vor, daß der Festkörper auf einer Seite des laseraktiven Volumenbereichs mit einem den internen Reflektor bildenden reflektierenden Volumenbereich versehen ist, wobei innerhalb dieses reflektierenden Volumenbereichs die Schichten angeordnet sind.

Eine besonders günstige Lösung sieht dabei vor, daß der reflektierende Volumenbereich einen als Braggreflektor ausgebildeten Bereich aufweist.

Erfindungsgemäß läßt sich der Festkörper insbesondere dann optimal kühlen, wenn der interne Reflektor in einem Abstand von der Kühlfläche angeordnet ist, der weniger als 100 µm beträgt.

Hinsichtlich des Verlaufs des Pumpstrahlungsfeldes in dem Festkörper wurden bislang keine näheren Angaben gemacht. So sieht ein vorteilhaftes Ausführungsbeispiel vor, daß das Pumpstrahlungsfeld den laseraktiven Volumenbereich in einer quer zu der Fläche, in der sich die Verstärkerstruktur erstreckt, verlaufenden Richtung mehrfach durchsetzt.

Eine besonders günstige Lösung sieht dabei vor, daß das Pumpstrahlungsfeld durch dieselbe Oberfläche des Festkörpers hindurchtritt wie das Laserverstärkerstrahlungsfeld.

Zweckmäßigerweise ist dabei diese Oberfläche die Oberfläche des Festkörpers, welche der Kühlfläche gegenüberliegend angeordnet ist.

Hinsichtlich der relativen Anordnung der Fläche, in der sich die Verstärkerstruktur erstreckt und der Durchtrittsfläche für das Pumpstrahlungsfeld sieht eine besonders günstige Lösung vor, daß sich die Fläche, in der die Verstärkerstruktur angeordnet ist, parallel zu einer Durchtrittsfläche des Festkörpers für das Pumpstrahlungsfeld erstreckt.

Hinsichtlich der Führung des Pumpstrahlungsfeldes auch bei mehrfachem Hindurchtreten desselben durch den Festkörper wurden bislang keine näheren Angaben gemacht. Beispielsweise wäre es denkbar, den Festkörper so anzuordnen, daß das Pumpstrahlungsfeld durch eine externe Optik geführt ist und der Festkörper lediglich so angeordnet ist, daß das Pumpstrahlungsfeld diesen mehrfach vollständig durchsetzt.

Besonders günstig ist es jedoch, wenn der Festkörper auf einer Seite des laseraktiven Volumenbereichs mit einem Reflektor für das Pumpstrahlungsfeld versehen ist.

Der Reflektor kann dabei auf eine Oberfläche des Festkörpers aufgetragen sein. Noch günstiger ist es jedoch, wenn der Reflektor ein im Festkörper angeordneter interner Reflektor ist.

Vorzugsweise ist dabei der Reflektor für das Pumpstrahlungsfeld durch eine Folge von Schichten gebildet.

Die Folge von Schichten könnte beliebig verteilt im Festkörper angeordnet sein.

Besonders zweckmäßig ist es jedoch, wenn der interne Reflektor für das Pumpstrahlungsfeld durch einen reflektierenden Volumenbereich gebildet ist, welcher seinerseits die Schichten umfaßt.

Eine günstige Ausbildung sieht vor, daß der reflektierende Volumenbereich einen als Braggreflektor ausgebildeten Bereich umfaßt.

In dem Fall, in dem der Festkörper sowohl einen internen Reflektor für das Laserverstärkerstrahlungsfeld als auch einen internen Reflektor für das Pumpstrahlungsfeld umfaßt, können diese beiden internen Reflektoren prinzipiell unabhängig voneinander ausgebildet sein, wobei dies voraussetzt, daß stets einer der Reflektoren für das jeweils andere Strahlungsfeld möglichst vollständig nichtabsorbierend sein sollte.

Eine besonders günstige Lösung sieht daher vor, daß der Reflektor für das Laserverstärkerstrahlungsfeld und der Reflektor für das Pumpstrahlungsfeld zu einem Reflektor zusammengefaßt sind.

Vorzugsweise ist dabei der Reflektor durch eine Folge von Schichten gebildet, deren Aufbau und Anordnung hinsichtlich der Wellenlänge und des Einfallswinkels des Laserverstärkerstrahlungsfeldes und der Wellenlänge und des Einfallswinkels des Pumpstrahlungsfeldes optimiert sind, so daß insbesondere aufgrund unterschiedlicher Einfallswinkel von Laserverstärkerstrahlungsfeld und Pumpstrahlungsfeld eine optimale Reflexion für beide Strahlungsfelder erreichbar ist.

Hinsichtlich der Ausdehnung der Verstärkerstruktur in Richtung der jeweils zugeordneten Fläche und somit quer zur Stapelrichtung wurden bislang keine näheren Angaben gemacht. Im einfachsten Fall ist vorgesehen, daß sich die Verstärkerstruktur quer zur Stapelrichtung und somit in Richtung der zugeordneten Fläche bis zu Randflächen des Festkörpers ausdehnt.

Um jedoch die Ausdehnung der Verstärkerstrukturen in Richtung der Fläche gering zu halten und somit in Richtung der Fläche eine Verstärkung für Strahlung bei der Wellenlänge einer Laserverstärkung zu unterdrücken, ist vorzugsweise vorgesehen, daß die Verstärkerstruktur quer zur Stapelrichtung eine Ausdehnung aufweist, die geringer ist als die des Festkörpers in dieser Richtung.

Dabei ist denkbar, daß in jeder einer Verstärkerstruktur zugeordneten Fläche nur eine Verstärkerstruktur vorgesehen ist.

Alternativ dazu ist es aber auch denkbar, daß in jeder Fläche mehrere nebeneinander angeordnete Verstärkerstrukturen vorgesehen sind.

Um die erfindungsgemäß ausgebildeten Verstärkerstrukturen optimal pumpen zu können, ist vorzugsweise vorgesehen, daß das Pumpstrahlungsfeld die Fläche, in welcher sich die jeweilige Verstärkerstruktur erstreckt, in einem Flächenbereich durchsetzt, welcher kleiner als die Ausdehnung der Verstärkerstruktur in Richtung der Fläche ist, so daß die Pumpstrahlung des Pumpstrahlungsfeldes optimal ausgenutzt werden kann.

Insbesondere bei der Mehrfachanregung ist vorzugsweise vorgesehen, daß das Pumpstrahlungsfeld bei jedem Durchgang durch die Fläche, in welcher die Verstärkerstruktur angeordnet ist, einen Flächenbereich durchsetzt und daß die Summe der Flächenbereiche einen zusammenhängenden Anregungsbereich gibt, insbesondere die Flächenbereiche möglichst weitgehend überlappen.

Eine weitere Lösung sieht vor, daß das Pumpstrahlungsfeld gleichzeitig nicht zusammenhängende Teilflächenbereiche der Fläche durchsetzt, in der die mindestens eine Verstärkerstruktur angeordnet ist, und die innerhalb dieser Flächenbereiche vorhandene mindestens eine Verstärkerstruktur optisch pumpt.

Ein derartiger Verlauf des Pumpstrahlungsfeldes läßt sich vorzugsweise dadurch erreichen, daß das Pumpstrahlungsfeld nicht zusammenhängende Pumplichtstrahlungsfeldsegmente aufweist, von denen jedes einen Teilflächenbereich der Fläche durchsetzt, in der die mindestens eine Verstärkerstruktur angeordnet ist.

Eine weitere verbesserte Ausführungsform der erfindungsgemäßen Lösung, die insbesondere die Verstärkung von Strahlung mit der Wellenlänge des Laserverstärkerstrahlungsfeldes unterdrückt, welche sich in Richtung der Fläche der Verstärkerstruktur ausbreitet, sieht vor, daß in Richtung quer zur Stapelrichtung aufeinanderfolgend angeordnete Verstärkerstrukturen optisch voneinander getrennt sind.

Vorzugsweise sind dabei die Verstärkerstrukturen durch Barrieren aus optisch absorbierenden Materialien voneinander getrennt, wobei die absorbierenden Materialien vorzugsweise hauptsächlich im Wellenlängenbereich einer Laserverstärkung der Quantenstrukturen absorbieren.

Besonders optimal ist die Unterdrückung unerwünschter Verstärkung in Richtung der Fläche, in welcher die Verstärkerstrukturen liegen, dann, wenn die Verstärkerstrukturen durch Barrieren aus optisch absorbierenden Materialien umschlossen sind.

Derartige Barrieren lassen sich besonders günstig dann ausführen, wenn die Barrieren aus optisch absorbierenden Materialien in den Flächen, in denen die Verstärkerstrukturen liegen, eine geschlossene Kontur bilden.

Um die Einkopplung und Auskopplung des Laserverstärkerstrahlungsfeldes zu optimieren ist vorzugsweise vorgesehen, daß der Festkörper auf einer Seite des laseraktiven Volumenbereichs für das Laserverstärkerstrahlungsfeld antireflektierend ausgebildet ist.

Dies könnte beispielsweise durch eine antireflektierende Schicht erfolgen.

Besonders günstig ist es jedoch, insbesondere wenn der Festkörper ohnehin aus einzelnen Schichten aufgebaut ist, wenn der Festkörper auf einer Seite des laseraktiven Volumenbereichs mit einem antireflektierenden Volumenbereich versehen ist.

Ein derartiger antireflektierender Volumenbereich besteht vorzugsweise aus einer Vielzahl von Schichten, die vorzugsweise ebenfalls aus Halbleitermaterial oder halbleiterähnlichem Material hergestellt sind.

Insbesondere sind der antireflektierende Volumenbereich und der den Reflektor bildende Volumenbereich auf in Stapelrichtung unterschiedlichen Seiten des laseraktiven Volumenbereichs angeordnet.

Um auch eine optimale Einkopplung des Pumpstrahlungsfeldes zu erreichen, ist vorzugsweise vorgesehen, daß der Festkörper auf einer Eintrittsseite des Pumpstrahlungsfeldes antireflektierend ausgebildet ist.

Vorzugsweise läßt sich die antireflektierende Ausbildung des Festkörpers durch einen antireflektierenden Volumenbereich erreichen.

Bei einer Ausführungsform tritt vorzugsweise das Pumpstrahlungsfeld quer zur Ausdehnung der mindestens einen Fläche des laseraktiven Volumenbereichs in den Festkörper ein. In diesem Fall ist der Festkörper auf einer Seite des laseraktiven Volumenbereichs für das Pumpstrahlungsfeld antireflektierend ausgebildet, wobei die antireflektierende Ausbildung darüber hinaus auch antireflektierend für das sich quer zum laseraktiven Volumenbereich erstreckende Verstärkerstrahlungsfeld sein soll.

Vorzugsweise ist bei dieser Lösung vorgesehen, daß der antireflektierende Volumenbereich und der den Reflektor bildende Volumenbereich auf in Stapelrichtung unterschiedlichen Seiten des laseraktiven Volumenbereichs angeordnet sind.

Im Rahmen der bisherigen Erläuterung der einzelnen Ausführungsbeispiele wurden lediglich Ausführungsbeispiele erwähnt, bei welchen das Pumpstrahlungsfeld durch dieselbe Oberfläche in den Festkörper eingetreten ist, durch die auch das Laserverstärkerstrahlungsfeld ausgetreten ist.

Alternativ oder ergänzend dazu ist bei einer weiteren bevorzugten Ausführungsform vorgesehen, daß das Pumpstrahlungsfeld ungefähr parallel zur Ausdehnung der mindestens einen Fläche des laseraktiven Volumenbereichs über eine Seitenfläche in den Festkörper eintritt.

Damit besteht die Möglichkeit, den Festkörper quer zum Laserverstärkerstrahlungsfeld zu pumpen.

Um die Verstärkerstrukturen dabei optimal optisch pumpen zu können, ist vorgesehen, daß das Pumpstrahlungsfeld divergent in den Festkörper eintritt und in diesem durch Reflexion in Richtung quer zur optischen Achse des Laserverstärkerstrahlungsfeldes geführt ist.

Durch das divergente Eintreten des Pumpstrahlungsfeldes in den Festkörper entsteht eine Strahlung in einer Vielzahl von Ausbreitungsrichtungen, die dann bei Reflexionen dazu führt, daß einerseits die Verstärkerstrukturen weitgehend mit gleichmäßiger Intensität gepumpt werden, und dabei der Effekt des Mehrfachdurchgangs des Pumpstrahlungsfeldes durch die Verstärkerstrukturen auftritt.

Die Reflexionen des Pumpstrahlungsfeldes in dem Festkörper sind durch unterschiedliche Maßnahmen erreichbar. Beispielsweise wäre es denkbar, spezielle, auf das Pumpstrahlungsfeld abgestimmte Reflektoren im Festkörper vorzusehen.

Die Reflektoren sind dann, wenn sie vom Laserverstärkerstrahlungsfeld durchsetzt sind, für dieses transparent auszubilden.

Eine besonders günstige Lösung sieht jedoch vor, daß die Reflexionen des Pumpstrahlungsfeldes durch Brechungsindexgradienten im Festkörper erfolgen, das heißt, daß die Reflexionen dadurch erfolgen, daß an dem jeweiligen Brechungsindexgradient der Grenzwinkel der Totalreflexion nicht unterschritten wird und somit stets Totalreflexion vorliegt.

Hinsichtlich der Ausbildung und der Festlegung des Laserverstärkerstrahlungsfeldes wurden bislang ebenfalls keine näheren Angaben gemacht. So sieht ein vorteilhaftes Ausführungsbeispiel vor, daß das Laserverstärkerstrahlungsfeld durch eine Verstärkeroptik definiert ist, die mindestens einen im Abstand vom Festkörper angeordneten externen Spiegel umfaßt, so daß die Verstärkeroptik Freiheitsgrade bietet, um das Laserverstärkerstrahlungsfeld optimal festzulegen.

Besonders günstig ist die erfindungsgemäße Lösung dann, wenn die Verstärkeroptik so ausgebildet ist, daß sie nur ein Laserstrahlungsfeld mit dem Grundmode oder mit dem Grundmode und noch grundmodenahen Moden zuläßt, so daß das Laserverstärkerstrahlungsfeld eine für alle Anwendungen, in denen es auf eine gute Fokussierung ankommt, vorteilhafte Modenstruktur aufweist.

Weitere Merkmale und Vorteile der Erfindung sind Gegenstand der nachfolgenden Beschreibung sowie der zeichnerischen Darstellung einiger Ausführungsbeispiele.

In der Zeichnung zeigen:
- Fig. 1: eine schematische Darstellung eines Schnitts durch ein erstes Ausführungsbeispiel eines erfindungsgemäßen Laserverstärkersystems;
- Fig. 2: einen vergrößerten Schnitt durch den Festkörpers des in Fig. 1 dargestellten ersten Ausführungsbeispiels des erfindungsgemäßen Laserverstärkersystems;
- Fig. 3: eine vergrößerte perspektivische Darstellung einer der in Fig. 2 dargestellten Flächen, in welchen sich eine Quantenstruktur erstreckt, mit vom Pumpstrahlungsfeld durchsetzten Flächenbereichen;
- Fig. 4: eine schematische Darstellung von energetischen Relationen zwischen Valenzband und Leitungsband innerhalb des Festkörpers, aufgetragen über den Abstand in Stapelrichtung;
- Fig. 5: eine schematische Darstellung ähnlich Fig. 1 eines zweiten Ausführungsbeispiels eines erfindungsgemäßen Laserverstärkersystems ohne Darstellung des Pumpstrahlungsfeldes;
- Fig. 6: eine schematische Darstellung einer Dämpfung von sich in Richtung quer zur optischen Achse ausbreitender Strahlung bei der Wellenlänge einer Laserverstärkung bei einem dritten Ausführungsbeispiel eines erfindungsgemäßen Laserverstärkersystems;
- Fig. 7: eine schematische Darstellung einer Temperaturverteilung im Festkörper im thermodynamischen Gleichgewichtszustandes bei Laserbetrieb bei einem vierten Ausführungsbeispiel des erfindungsgemäßen Laserverstärkersystems;
- Fig. 8: eine schematische Darstellung ähnlich Fig. 4 der Energierelationen zwischen Valenz- und Leitungsband in Abhängigkeit von der Temperatur bei dem vierten Ausführungsbeispiel;
- Fig. 9: eine schematische Darstellung eines Verstärkungsprofils des vierten Ausführungsbeispiels bei idealem Abstand der Quantenstrukturen in Ausbreitungsrichtung des Laserverstärkerstrahlungsfeldes;
- Fig. 10: eine Darstellung eines Verstärkerprofils bei einem fünften Ausführungsbeispiel eines erfindungsgemäßen Laserverstärkersystems;
- Fig. 11: eine schematische Darstellung einer Anordnung der Quantenstrukturen bei dem fünften Ausführungsbeispiel in Abweichung von der idealen Anordnung mit schematischer Darstellung der zugehörigen elektrischen Feldverteilung der Lasermode;
- Fig. 12: eine schematische Darstellung einer in einer Fläche liegenden Quantenstruktur eines sechsten Ausführungsbeispiels des erfindungsgemäßen Laserverstärkersystems;
- Fig. 13: eine schematische Darstellung einer eine Variante einer Verstärkeroptik des sechsten Ausführungsbeispiels;
- Fig. 14: eine schematische Darstellung einer zweiten Variante einer Verstärkeroptik des sechsten Ausführungsbeispiels;
- Fig. 15: eine schematische Darstellung einer in einer Fläche angeordneten Quantenstruktur eines siebten Ausführungsbeispiels;
- Fig. 16: eine schematische Darstellung einer in einer Fläche angeordneten Quantenstruktur eines achten Ausführungsbeispiels;
- Fig. 17: eine schematische Darstellung einer in einer Fläche angeordneten Quantenstruktur eines neunten Ausführungsbeispiels eines erfindungsgemäßen Laserverstärkersystems;
- Fig. 18: eine schematische Darstellung einer in einer Fläche angeordneten Quantenstruktur eines zehnten Ausführungsbeispiels eines erfindungsgemäßen Laserverstärkersystems;
- Fig. 19: eine schematische ausschnittsweise Darstellung von sich in Stapelrichtung über den laseraktiven Volumenbereich erstreckenden Barrieren bei dem zehnten Ausführungsbeispiel;
- Fig. 20: eine schematische Darstellung ähnlich Fig. 1 eines elften Ausführungsbeispiels;
- Fig. 21: eine schematische Darstellung ähnlich Fig. 1 eines zwölften Ausführungsbeispiels;
- Fig. 22: eine vergrößerte ausschnittsweise Darstellung eines Bereichs X in Fig. 21;
- Fig. 23: eine schematische Darstellung ähnlich Fig. 1 eines dreizehnten Ausführungsbeispiels.

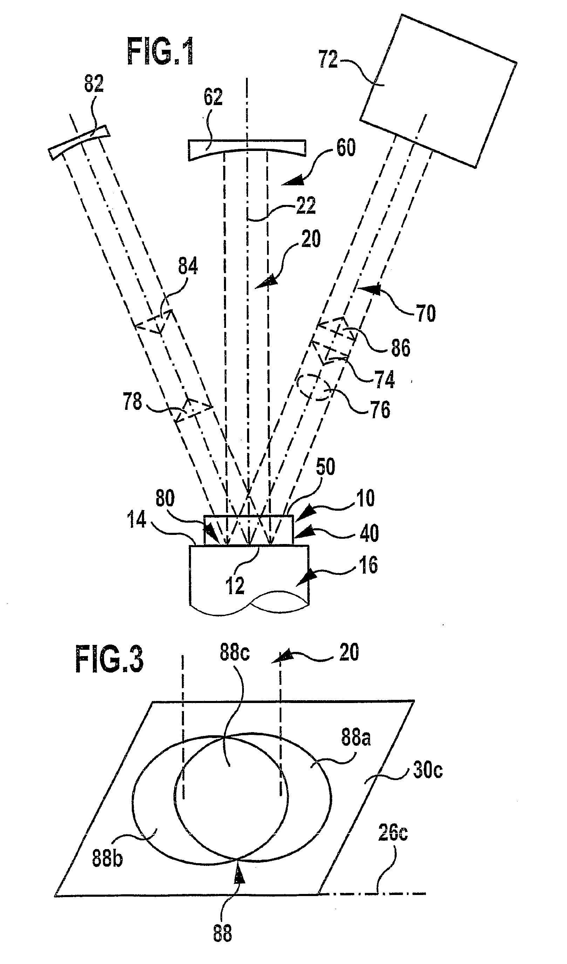

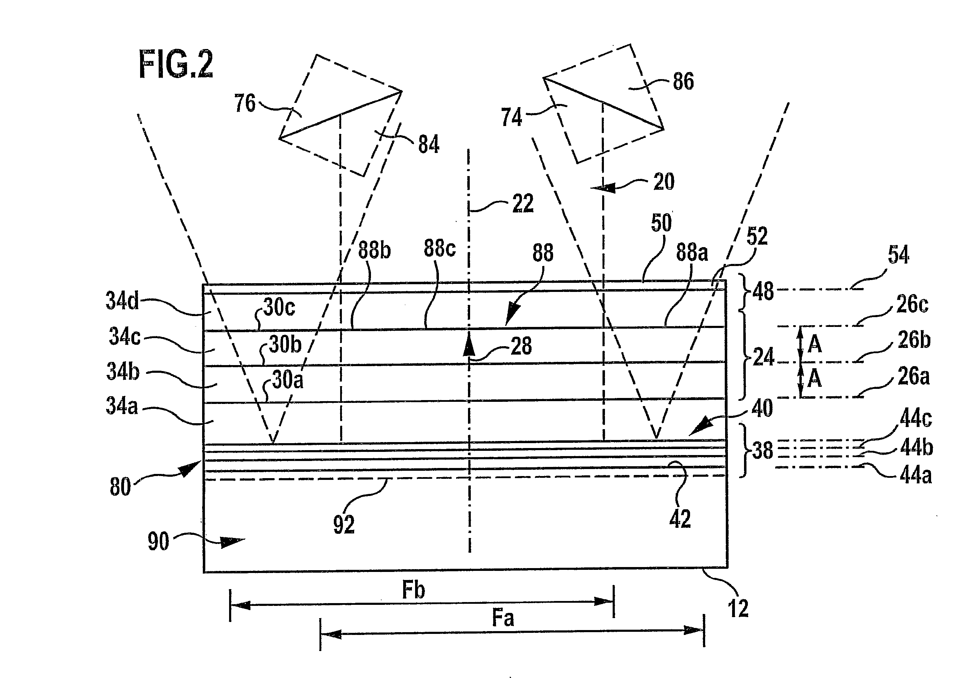

Ein erstes Ausführungsbeispiel eines erfindungsgemäßen Laserverstärkersystems, dargestellt in Fig. 1 und Fig. 2 umfaßt einen Festkörper 10, welcher mit einer Kühlfläche 12 auf einer Oberfläche 14 eines Kühlkörpers 16 angeordnet ist, wobei durch das flächige Auflegen der Kühlfläche 12 auf der Oberfläche 14 eine gute thermische Kopplung zwischen dem Kühlkörper 16 und dem Festkörper 10 erfolgt.

Der Festkörper 10 dient zur optischen Verstärkung eines Laserverstärkerstrahlungsfeldes 20, welches den Festkörper 10 durchsetzt und sich beispielsweise längs einer optischen Achse 22 ausbreitet.

Zum Verstärken des Laserverstärkerstrahlungsfeldes 20 ist - wie in Fig. 2 dargestellt - in dem Festkörper 10 ein laseraktiver Volumenbereich 24 vorgesehen, welcher sich in parallel zueinander verlaufenden und übereinander liegenden Flächen 26a bis 26c erstreckende als Quantenstrukturen 30a, 30b und 30c ausgebildete Verstärkerstrukturen aufweist, die aus einem Halbleitermaterial hergestellt sind und quer zu den Flächen 26 eine Dicke aufweisen, die maximal in der Größenordnung des Zehnfachen, noch besser des einfachen der Wellenlänge der Elektronen in dem die Quantenstruktur bildenden Halbleitermaterial sind. Typischerweise beträgt beispielsweise beim Halbleitermaterial GaAs die Dicke ungefähr 5 bis ungefähr 100 nm, vorzugsweise jedoch ungefähr 5 bis ungefähr 10 nm.

Damit legen die Quantenstrukturen 30a bis 30c eine Ausdehnung eines in diesem vorhandenen Elektronengases fest, so daß ein dimensionslimitiertes Elektronengas vorliegt. Die Quantenstrukturen 30a bis 30c können beispielsweise als sich in den Flächen 26 erstreckende Filme mit einem zweidimensionalen Elektronengas, in den Flächen 26 erstreckende Quantendrähte mit einem eindimensionalen Elektronengas oder auch in den Flächen 26 angeordnete Quantenpunkte mit einem nulldimensionalen Elektronengas ausgebildet sein.

Eine Beschreibung derartiger Quantenstrukturen findet sich beispielsweise in dem Buch von Karl Joachim Ebeling, Integrierte Optoelektronik, Springer Verlag 1992, Seite 215 bis 221.

Vorzugsweise erstrecken sich dabei die Flächen 26 ungefähr parallel zur Kühlfläche 12 und vorzugsweise quer zur optischen Achse 22, noch besser senkrecht zur optischen Achse 22 des Laserverstärkerstrahlungsfeldes 20, wobei die Flächen 26 in einer Stapelrichtung 28 einen Abstand A voneinander aufweisen, welcher in der Größenordnung der halben Wellenlänge oder eines ganzzahligen Vielfachen der halben Wellenlänge des Laserverstärkerstrahlungsfeldes 20 liegt.

Alternativ zum äquidistanten Anordnen der Flächen 26 besteht auch die Möglichkeit, Gruppen extrem nah beieinanderliegender Flächen mit in diesen vorgesehenen Quantenstrukturen vorzusehen und zwischen den Flächen unterschiedlicher Gruppen einen Abstand A vorzusehen, welcher in der Größenordnung des ganzzahligen Vielfachen der halben Wellenlänge des Laserverstärkerstrahlungsfeldes 20 liegt.

Da die Quantenstrukturen 30 Schichten aus Halbleitermaterial sind, liegen diese vorzugsweise jeweils zwischen beidseitig an die entsprechende Fläche 26a bis 26c angrenzenden Umgebungsstrukturen 34a, 34b, 34c und 34d, wobei beispielsweise die Umgebungsstrukturen 34a und 34b beiderseits der Fläche 26a angeordnet sind und somit die Quantenstruktur 30a in der Stapelrichtung 28 betrachtet zwischen sich einschließen.

Auch die Umgebungsstrukturen 34 sind vorzugsweise aus Halbleitermaterial. Besonders zweckmäßig ist es, wenn die Umgebungsstruktur dieselbe Kristallstruktur und Gitterkonstante wie das Halbleitermaterial der Quantenstruktur 30 aufweist, so daß die Halbleitermaterialien der Umgebungsstrukturen 34 vorzugsweise im wesentlichen ähnliche Halbleitermaterialien sind. Vorzugsweise haben dabei die Umgebungsstrukturen 34 eine Dicke, die größer ist als die Dicke der an diese angrenzenden Quantenstruktur, noch besser ein Mehrfaches der Quantenstruktur 30.

Insbesondere weisen die Umgebungsstrukturen 34 Dicken auf, deren Mindestwerte im Bereich von 10 nm bis 100 nm liegen.

Die Umgebungsstrukturen 34, die zwischen zwei in der Stapelrichtung 28 aufeinanderfolgend angeordneten Quantenstrukturen 30 liegen, können dabei insgesamt eine Zwischenschicht bilden, die den Abstand zwischen den in Stapelrichtung 28 aufeinanderfolgend angeordneten Quantenstrukturen 30 definiert.

Es ist aber auch denkbar, zwischen zwei in der Stapelrichtung 28 aufeinanderfolgenden Umgebungsstrukturen 34, und zwar auf deren jeweils der Quantenstruktur 30 abgewandten Seite, noch eine weitere Schichtstruktur vorzusehen, so daß insgesamt die Zwischenschicht aus den Umgebungsstrukturen 34 und der zwischen diesen liegenden Zwischenstruktur gebildet ist.

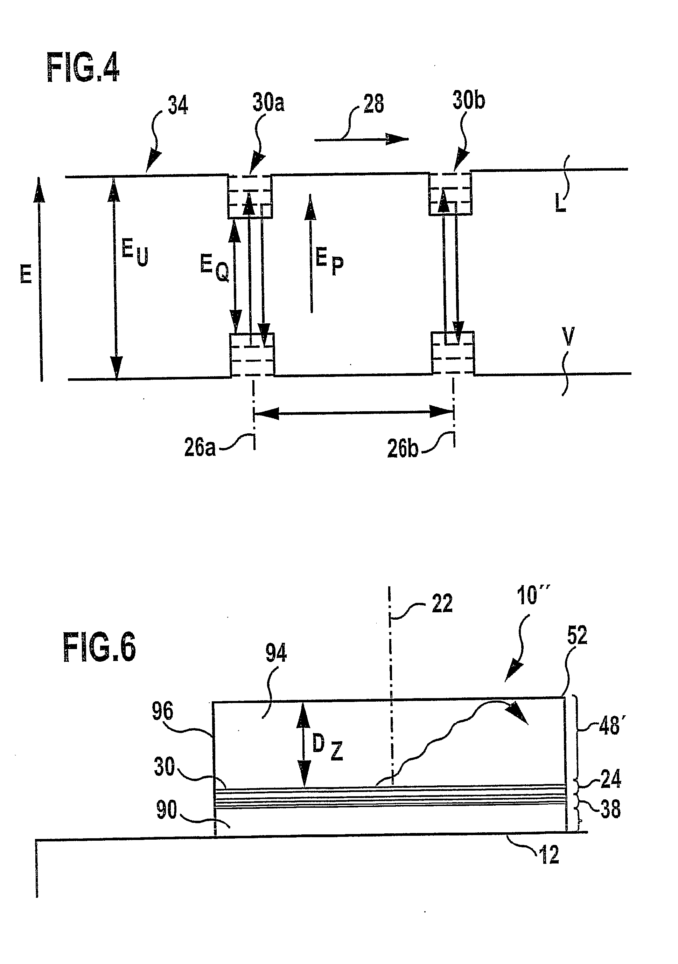

Allerdings ist, wie in Fig. 4 dargestellt, der Bandabstand E_{U} der Umgebungsstrukturen 34 erheblich grösser als der Bandabstand E_{Q} der Quantenstrukturen 30.

Vorzugsweise ist die Differenz zwischen den Bandabständen E_{U} und E_{Q} deutlich unterschiedlich, wie nachfolgend im einzelnen im Zusammenhang mit dem optischen Pumpen der Quantenstrukturen 30 dargelegt wird.

Darüber hinaus umfaßt der Festkörper 10 vorzugsweise einen reflektierenden Volumenbereich 38, in welchem mehrere, einen Braggreflektor 40 bildende Schichten 42 angeordnet sind, die sich ebenfalls quer, vorzugsweise senkrecht zur optischen Achse 22 in Flächen 44 erstrecken, die insbesondere im wesentlichen parallel zu den Flächen 26 verlaufen.

Der reflektierende Volumenbereich 38 ist dabei zwischen dem laseraktiven Volumenbereich 24 und der Kühlfläche 12 angeordnet.

Ferner umfaßt der Festkörper 10 noch zusätzlich einen antireflektierenden Volumenbereich 48, welcher auf einer dem reflektierenden Volumenbereich 38 gegenüberliegenden Seite des laseraktiven Volumenbereichs 24 angeordnet ist und sich an eine Austrittsfläche 50 des Festkörpers 10 für das Laserverstärkerstrahlungsfeld 20 anschließt.

Vorzugsweise ist dabei auch der antireflektierende Volumenbereich 48 aus mindestens einer Schicht 52 gebildet, welche sich in einer Fläche 54 erstreckt, die insbesondere ebenfalls parallel zu den Flächen 26 und den Flächen 44 verläuft und sich dabei quer, vorzugsweise senkrecht zur optischen Achse 22 erstreckt.

Darüber hinaus ist auch die Austrittsfläche 50 so ausgebildet, daß diese ungefähr parallel zu den Flächen 26, 44 und 54 verläuft.

Der Braggreflektor 40 in dem reflektierenden Volumenbereich 38 bildet einen Spiegel einer als Ganzes mit 60 bezeichneten Verstärkeroptik, während ein zweiter beispielsweise teildurchlässiger Spiegel 62 der Verstärkeroptik 60 im Abstand von der Austrittsfläche 50, vorzugsweise in einem großen Abstand von dieser angeordnet ist. Die Verstärkeroptik 60 ist dabei so ausgebildet, daß das Laserverstärkerstrahlungsfeld 20 üblicherweise das Laserverstärkerstrahlungsfeld 20 des Grundmodes der Verstärkeroptik 60 darstellt und eventuell noch zusätzliche höhere Moden, allerdings im wesentlichen nur grundmodenahe Moden umfaßt.

Ein Pumpen der Quantenstrukturen 30 im laseraktiven Volumenbereich 24 erfolgt durch ein als Ganzes mit 70 bezeichnetes Pumpstrahlungsfeld, welches ausgehend von einer Pumpstrahlungsquelle 72 den Festkörper 10 mehrfach durchsetzt.

Beispielsweise verläuft beim ersten Ausführungsbeispiel ein erster Ast 74 des Pumpstrahlungsfeldes 70 von der Pumpstrahlungsquelle 72 ausgehend in den Festkörper 10 hinein, durchsetzt den laseraktiven Volumenbereich 24 und pumpt dabei die Quantenstrukturen 30, die innerhalb seines Querschnitts 76 liegen.

Nachfolgend erfolgt eine Reflexion des Pumpstrahlungsfeldes 70 an einem Reflektor 80 für das Pumpstrahlungsfeld 70 und somit durch den Reflektor 80 ein Abbilden des ersten Astes 74 in einen zweiten Ast 78, welcher von dem Reflektor 80 ausgehend in Richtung eines Umlenkspiegels 82 verläuft, wobei somit auch der zweite Ast 78 den laseraktiven Volumenbereich 24 durchsetzt und dabei die innerhalb von dessen Querschnitt liegenden Quantenstrukturen 30 optisch pumpt. Im Umlenkspiegel 82 erfolgt dann beispielsweise eine Rückreflexion des Pumpstrahlungsfeldes 70 und somit ein Abbilden des zweiten Astes 78 in einen dritten Ast 84, der exakt entgegengesetzt zum zweiten Ast 78 verläuft und somit wiederum in den Festkörper 10 eintritt, den laseraktiven Volumenbereich 24 durchsetzt, innerhalb seines Querschnitts liegende Quantenstrukturen 30 optisch pumpt und am Reflektor 80 reflektiert wird und damit in einen vierten Ast 86 des Pumpstrahlungsfeldes 70 abgebildet wird, welcher sich ausgehend vom Reflektor 80 wiederum in Richtung der Pumplichtstrahlungsquelle 72 erstreckt und damit erneut den laseraktiven Volumenbereich 24 durchsetzt und die innerhalb von dessen Querschnitt liegenden Quantenstrukturen 30 optisch pumpt.

Insgesamt durchsetzt somit das Pumpstrahlungsfeld 70 den laseraktiven Volumenbereich 24 vier Mal, so daß selbst bei geringer Absorption des Pumpstrahlungsfeldes 70 durch die Quantenstrukturen 30 ein effizientes Mehrfachpumpen derselben erfolgen kann.

Der Reflektor 80 ist bei dem dargestellten ersten Ausführungsbeispiel ebenfalls als Braggreflektor ausgebildet und wird auch durch den Braggreflektor 40 gebildet, das heißt, daß der Braggreflektor 40 hinsichtlich der Zahl und des Abstandes der Schichten 42 so dimensioniert ist, daß er einerseits möglichst gut reflektierend für das sich längs der optischen Achse 22 ausbreitende Laserverstärkerstrahlungsfeld 20 ausgebildet ist, und andererseits möglichst gut reflektierend für das unter einem spitzen Winkel zur optischen Achse 22 einfallende Pumpstrahlungsfeld 70 ausgebildet ist.

Da beide Strahlungsfelder 20, 70 in unterschiedlichen Winkeln auf die Schichten 42 auftreffen, ist eine Optimierung des Braggreflektors 40, 80 auf zwei unterschiedliche Wellenlängen möglich.

Besonders günstig ist es dabei, wenn die kürzerwellige Strahlung in einem größeren Einfallswinkel einfällt als die langwelligere Strahlung.

Alternativ ist es aber auch im Rahmen einer Variante möglich, den Reflektor 80 auf einer dem laseraktiven Volumenbereich 24 abgewandten Seite des Braggreflektors 40 anzuordnen, wobei in diesem Fall der Braggreflektor 40 dann für das Pumpstrahlungsfeld nichtabsorbierend ausgebildet sein muß.

Eine andere Möglichkeit wäre auch, den Reflektor 80 als reflektierende Schicht auszubilden, die beispielsweise auf der Kühlfläche 12 aufliegend angeordnet ist.

Durch die Reflexion des Pumpstrahlungsfeldes 70 und die Ausbildung der Äste 74 und 78 sowie 84 und 86 desselben wird beispielsweise die Fläche 26c, in welcher sich die Quantenstruktur 30c erstreckt, einerseits in einem Flächenbereich 88a mit einer Flächenausdehnung Fₐ durchsetzt, und zwar durch die Äste 74 und 86, und andererseits in einem Flächenbereich 88b mit einer Flächenausdehnung F_{b}, und zwar durch die Äste 78 und 84.

Dabei überlappen die Flächenbereiche 88a und 88b weitgehend und geben insgesamt einen zusammenhängenden Anregungsbereich 88 (Fig. 3), wobei allerdings lediglich im Überlappungsbereich 88c der Flächenbereiche 88a und 88b ein im wesentlichen homogenes Pumpen der Quantenstruktur 30c erfolgt, so daß vorzugsweise das Laserverstärkerstrahlungsfeld 20 in Richtung der Fläche 26c eine Ausdehnung aufweist, die sich im wesentlichen über den Überlappungsbereich 88c der Flächenbereiche 88a und 88b erstreckt, insbesondere nicht über diesen hinausreicht.

Die gleichen Betrachtungen gelten für die übrigen Quantenstrukturen, beispielsweise die Quantenstrukturen 30a und 30b in den Flächen 26b und 26a, wobei allerdings die am weitesten vom Reflektor 80 entfernte Quantenstruktur 30c den kleinsten Überlappungsbereich 88c der Flächenbereiche 88a und 88b aufweist.

In den Fig. 1 und 2 ist der Verlauf der Äste 74, 76, 84, 86 relativ zur optischen Achse 22 des Laserverstärkerstrahlungsfeldes 20 insoweit nicht realistisch sondern nur schematisch dargestellt als aufgrund der höheren Brechzahl innerhalb des Festkörpers 10 der Winkel zur optischen Achse 22 geringer ist als außerhalb des Festkörpers.

Die im Zusammenhang mit dem ersten Ausführungsbeispiel dargestellte Lösung, bei welcher das Pumpstrahlungsfeld 70 die jeweilige Quantenstruktur mehrfach durchsetzt, stellt den einfachsten Fall einer derartigen Führung des Pumpstrahlungsfeldes 70 dar.

Komplexere Formen der Führung des Pumpstrahlungsfeldes 70 sind beispielsweise in der europäischen Patentanmeldung 0 632 551 oder in der deutschen Patentanmeldung 100 05 195 oder der deutschen Patentanmeldung 198 35 107 oder der deutschen Patentanmeldung 198 35 108 beschrieben.

Bei der erfindungsgemäßen Lösung ist, wie bereits anhand der Fig. 4 erläutert, der Bandabstand E_{Q} zwischen dem oberen Valenzband V und dem unteren Leitungsband L des die Quantenstrukturen 30 bildenden Halbleitermaterials deutlich geringer als der Bandabstand E_{U} des die Umgebungsstrukturen 34 bildenden Halbleitermaterials, so daß die Möglichkeit besteht, die Lichtwellenlänge und damit die Energie der Photonen E_{P} des Pumpstrahlungsfeldes 70 so zu wählen, daß mit dem Pumpstrahlungsfeld 70 lediglich ein optisches Pumpen des Halbleitermaterials der Quantenstrukturen 30 erfolgt und vorzugsweise kein optisches Pumpen des Halbleitermaterials der Umgebungsstrukturen 34 und auch kein optisches Pumpen anderer, den Festkörper 10 bildender Materialien.

Vielmehr ist der Festkörper 10 so aufgebaut, daß der Festkörper 10 abgesehen von den Quantenstrukturen 30 und dem Reflektor 80 eine möglichst gute Transparenz für das Pumpstrahlungsfeld 70 und das Laserverstärkerstrahlungsfeld 20 aufweist.

Der erfindungsgemäße Festkörper 10 ist vorzugsweise durch Epitaxie auf einem Substrat 90 hergestellt, wobei unmittelbar auf dem Substrat 90 zunächst der reflektierende Volumenbereich 38 mit den die Braggreflektoren 40, 80 bildenden Schichten 42 aufgebaut wird, dann folgt beispielsweise im einfachsten Fall die Umgebungsstruktur 34, auf welcher dann die Quantenstruktur 30a aufgetragen wird. Auf diese Quantenstruktur 30a folgen dann weitere Umgebungsstrukturen, beispielsweise die Umgebungsstruktur 34b, dann wieder die Umgebungsstruktur 34c, auf diese die Quantenstruktur 30c und schließlich die Umgebungsstruktur 34d. Es können aber auch noch mehr Quantenstrukturen 30 und Umgebungsstrukturen aufeinander folgen, die alle den laseraktiven Volumenbereich 24 bilden.

Auf diesem laseraktiven Volumenbereich 24 werden schließlich der antireflektierende Volumenbereich 48 mit beispielsweise einer Antireflexschicht 52 aufgetragen.

Zwischen dem laseraktiven Volumenbereich 24 und dem antireflektierenden Volumenbereich 48 sind gegebenenfalls noch weitere Funktionsschichten, wie beispielsweise Passivierungsschichten, vorgesehen.

Um eine möglichst günstige Ankopplung des gesamten Festkörpers über die Kühlfläche 12 an den Kühlkörper 16 zu erhalten, wird vorzugsweise ein möglichst dünnes Substrat 90 gewählt, oder es wird das Substrat 90 nach Aufbau des reflektierenden Volumenbereichs 38, des laseraktiven Volumenbereichs 24 und des antireflektierenden Volumenbereichs 48 bis zu einer Ätzstoppschicht 92 wieder abgetragen, die beispielsweise auf dem Substrat 90 unmittelbar vor Auftragen des reflektierenden Volumenbereichs 38 vorgesehen wird.

Dadurch besteht die Möglichkeit, den Abstand zwischen der Kühlfläche 12 und dem reflektierenden Volumenbereich 38 und somit auch den Abstand zwischen der Kühlfläche 12 und dem laseraktiven Volumenbereich 24, der aufgrund der Absorption des Pumpstrahlungsfeldes 70 erwärmt wird und somit möglichst effizient gekühlt werden muß, möglichst gering zu halten.

Generell wird angestrebt, daß der Abstand zwischen dem reflektierenden Volumenbereich 38 und der Kühlfläche 12 des Festkörpers 10 möglichst weniger als 100 µm beträgt.

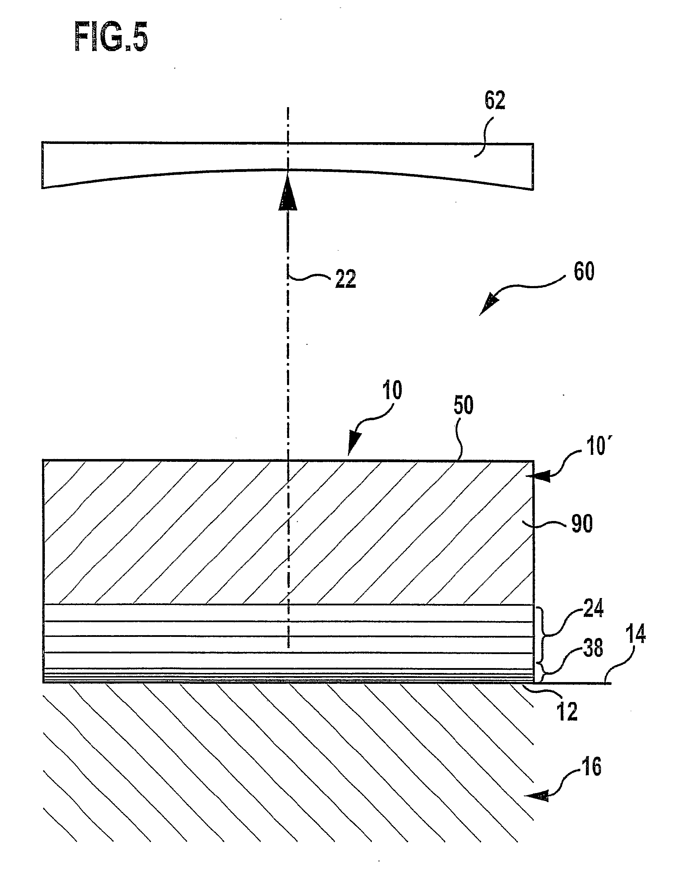

Bei einem zweiten Ausführungsbeispiel eines erfindungsgemäßen Laserverstärkersystems, dargestellt in Fig. 5, wird der Festkörper 10' vorzugsweise so aufgebaut, daß auf dem Substrat 90 zuerst der laseraktive Volumenbereich 24 und im Anschluß daran der reflektierende Volumenbereich 38 aufgebaut werden, so daß die reflektierende Volumenbereich 38 die zuletzt aufgebrachten Schichten des Festkörpers 10 bildet und dann die Kühlfläche 12 des Festkörpers 10' durch die oberste Schicht des reflektierenden Volumenbereichs 38 gebildet wird, so daß beim Aufsetzen des Festkörpers 10' mit der Kühlfläche 12 auf der Oberfläche 14 des Kühlkörpers 16 der Abstand zwischen dem reflektierenden Volumenbereich 38 und der Kühlfläche 12 der geringst mögliche sein kann.

Bei diesem zweiten Ausführungsbeispiel wird dann anschließend der antireflektierende Volumenbereich 48 durch eine Antireflexschicht gebildet, die auf einer dem laseraktiven Volumenbereich 24 gegenüberliegenden Seite des Substrats 90 aufgetragen wird und die Austrittsfläche 50 bildet.

Hinsichtlich der nicht im Detail erläuterten Merkmale ist das zweite Ausführungsbeispiel in gleicher Weise ausgebildet wie das erste Ausführungsbeispiel, so daß vollinhaltlich auf die Ausführungen zum ersten Ausführungsbeispiel Bezug genommen werden kann.

Bei einem dritten Ausführungsbeispiel eines erfindungsgemäßen Laserverstärkersystems, dargestellt in Fig. 6, ist zur Vermeidung von Wellenleitung quer zur optischen Achse 22 des Laserverstärkungsfeldes, insbesondere im antireflektierenden Volumenbereich 48', dieser so ausgebildet, daß zwischen der diesem antireflektierenden Volumenbereich 48' nächstliegenden Quantenstruktur 30 und der Antireflexschicht 52 ein optisch inaktiver Zwischenbereich 94 besteht, welcher eine Dicke D_{Z} aufweist, die ein Mehrfaches der Wellenlänge der Strahlung im Laserverstärkerstrahlungsfeld 20 beträgt, so daß zwischen der dem antireflektierenden Volumenbereich 48' nächstliegenden Quantenstruktur 30 und der Antireflexschicht 52, die in diesem Fall als Reflektorschicht wirkt, keine günstigen Verstärkungsverhältnisse in Richtung einer Seitenwand 96 des Festkörpers 10 bestehen.

Auch das dritte Ausführungsbeispiel ist hinsichtlich der im übrigen nicht im Detail beschriebenen Merkmale in gleicher Weise ausgebildet wie das erste und das zweite Ausführungsbeispiel, so daß auf die Ausführungen zu diesen Ausführungsbeispielen vollinhaltlich Bezug genommen werden kann.

Wie im Zusammenhang mit dem ersten Ausführungsbeispiel erläutert und in Fig. 1 und 2 dargestellt, weisen die Flächen 26, in Fig. 2 die Flächen 26a und 26b, in denen sich die Quantenstrukturen 30, in Fig. 2 die Quantenstrukturen 30a und 30b, erstrecken, einen Abstand in Stapelrichtung 28 auf, welcher vorzugsweise der halben Wellenlänge des Laserverstärkerstrahlungsfeldes 20 oder einem ganzzahligen Vielfachen der halben Wellenlänge des Laserverstärkerstrahlungsfeldes 20 entspricht, so daß damit sichergestellt ist, daß das Laserverstärkerstrahlungsfeld 20, welches sich in Richtung der optischen Achse 22 ausbreitet, stets an Stellen maximaler Amplitude durch die Quantenstrukturen 30 verstärkt wird.

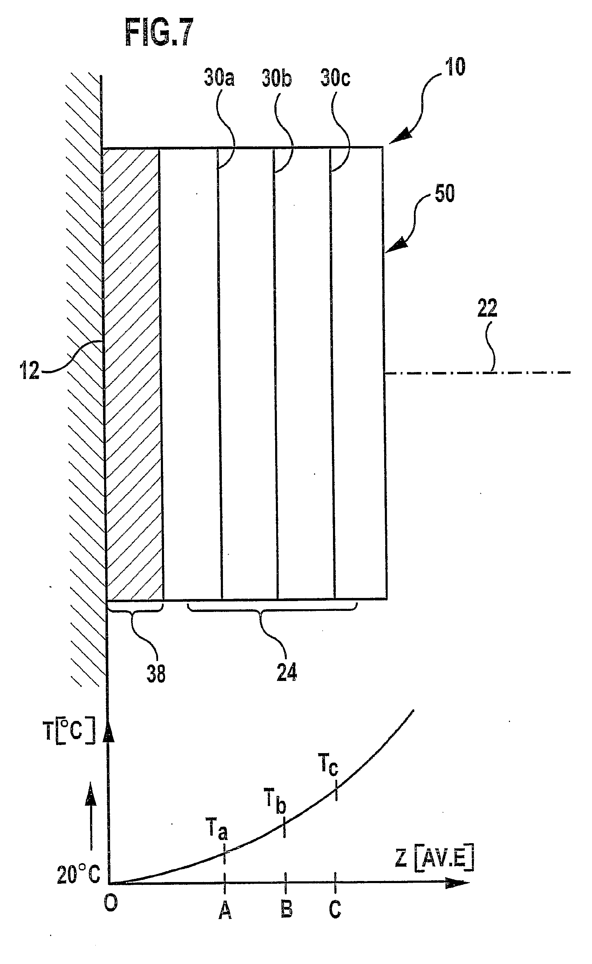

Da ebenfalls im Zusammenhang mit dem ersten Ausführungsbeispiel erläutert wurde, daß die Abfuhr der Wärme im wesentlichen vollflächig über die Kühlfläche 12 zu erfolgen hat, ergibt sich daraus im Fall eines vierten, in Fig. 7 dargestellten Ausführungsbeispiels, daß sich ein im Festkörper 10 in Richtung der optischen Achse 22 verlaufender Temperaturgradient einstellt, der in allen Richtungen quer zur optischen Achse 22 in allen Bereichen innerhalb des Laserverstärkerstrahlungsfeldes 20 im wesentlichen gleich groß ist, so daß die Temperatur im Festkörper 10, so wie in Fig. 7 dargestellt, mit zunehmendem Abstand von der Kühlfläche 12 ansteigt. Im Fall der Quantenstrukturen 30a, 30b und 30c führt dies dazu, daß die Temperatur Tₐ der Quantenstruktur 30a niedriger ist als die Temperatur T_{b} der Quantenstruktur 30b und die Temperatur T_{b} geringer ist als die Temperatur T_{c} der Quantenstruktur 30c.

Ein derartiger Temperaturgradient im Festkörper 10 hat bei den meisten Halbleitermaterialien zur Folge, daß mit zunehmender Temperatur der Bandabstand zwischen dem Valenzband V für die Löcher und dem Leitungsband L für die Elektronen geringer wird.

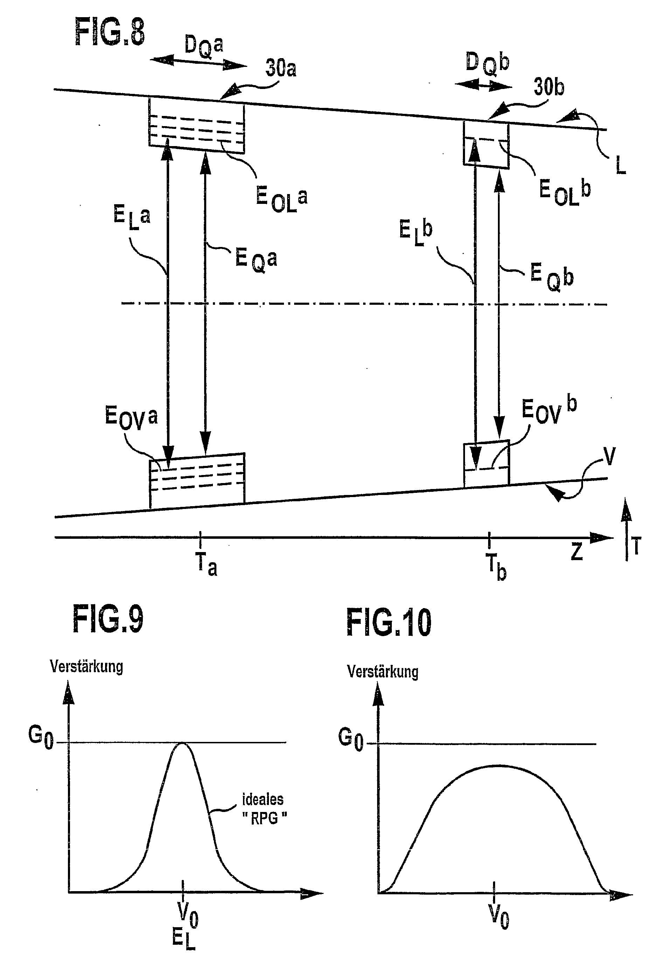

Aus diesem Grund ist beispielsweise der Bandabstand E_{Q}b der Quantenstruktur 30b kleiner als der Bandabstand E_{Q}a der Quantenstruktur 30a. (Fig. 8)

Die Energie, mit welcher Licht von einer jeweiligen Quantenstruktur 30 emittiert wird, hängt jedoch nicht vom Bandabstand E_{Q} ab, sondern vom Bandabstand E_{Q} plus der jeweiligen Nullpunktsenergie E_{OL} für die Elektronen und E_{OV} für die Löcher. Damit besteht die Möglichkeit, die Energie des emittierten Lichts E_{L} durch Verschiebung der Nullpunktsenergie in den einzelnen Quantenstrukturen 30, beispielsweise den Quantenstrukturen 30a und 30b, zu variieren und somit zu erreichen, daß die Energie E_{L}a des emittierten Lichts der Quantenstruktur 30a ungefähr gleich groß ist wie die Energie E_{L}b der Quantenstruktur 30b, obwohl der Bandabstand E_{Q}a größer ist als der Bandabstand E_{Q}b. Eine derartige Variation der Nullpunktsenergie E_{0L} im Leitungsband und E_{0V} im Valenzband ist dadurch erreichbar, daß man entweder die Zusammensetzung und/oder die Ausdehnung in der dimensionsbegrenzten Richtung, beispielsweise die Dicke der jeweiligen zweidimensionalen Quantenstruktur 30, beispielsweise der Quantenstruktur 30a oder 30b, variiert (Fig. 8).

Damit besteht die Möglichkeit, trotz unterschiedlicher Temperaturen Tₐ, T_{b}, T_{c} in den einzelnen Quantenstrukturen 30, beispielsweise den Quantenstrukturen 30a, 30b und 30c, zu erreichen, daß die Energie der emittierten Laserstrahlung E_{L} in allen Quantenstrukturen 30, beispielsweise den Quantenstrukturen 30a, 30b, 30c, im wesentlichen gleich groß ist, so daß eine optimale Verstärkung des Laserverstärkerstrahlungsfeldes 20 erfolgt.

Im übrigen ist das Laserverstärkersystem bei diesem Ausführungsbeispiel identisch aufgebaut, wie beim ersten Ausführungsbeispiel, so daß auf die Ausführungen zum ersten Ausführungsbeispiel vollinhaltlich Bezug genommen werden kann.

Durch diese Berücksichtigung unterschiedlicher Temperaturen Tₐ, T_{b}, T_{c} wird, wie in Fig. 9 dargestellt, ein Verstärkungsprofil im Laserverstärkerstrahlungsfeld 20 erreicht, welches eine geringe Bandbreite um die Energie E_{L} herum aufweist, der die Frequenz f₀ entspricht.

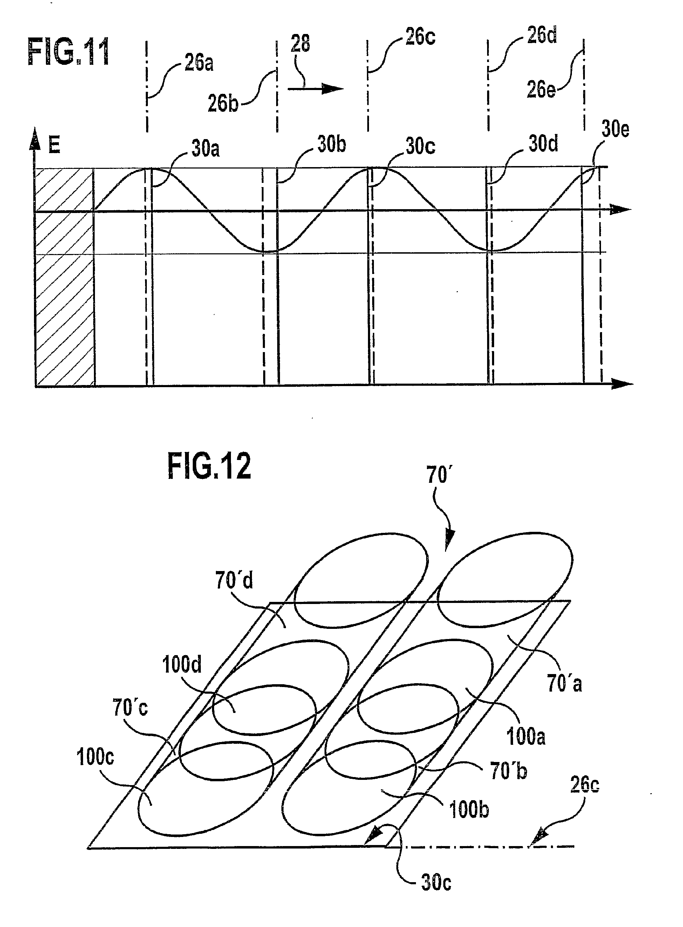

Besteht jedoch die Forderung, wie in Fig. 10 dargestellt, ein um die Frequenz fₒ spektral verbreitertes Verstärkungsprofil zu erhalten, ist bei einem fünften, in Fig. 11 dargestellten Ausführungsbeispiel vorgesehen, daß die Flächen 26, in welchen die Quantenstrukturen 30 liegen, nicht exakt in Stapelrichtung 28 im Abstand einer halben Wellenlänge des Laserverstärkerstrahlungsfeldes 20 oder eines ganzzahligen Vielfaches der halben Wellenlänge angeordnet sind, sondern durch geringfügige Abweichungen von der halben Wellenlänge variierende Abstände aufweisen. Beispielsweise ist die Quantenstruktur 30b in der Fläche 26b in einem Abstand von der Quantenstruktur 30a, die sich in der Fläche 26a erstreckt, angeordnet, der größer ist als die halbe Wellenlänge, während wiederum die Quantenstruktur 30c, die sich in der Fläche 26c erstreckt, so angeordnet ist, daß sie ungefähr in dem Abstand eines Vielfachen der halben Wellenlänge von der Quantenstruktur 30a angeordnet ist.

Das gleiche gilt für die Quantenstruktur 30d, welche sich in der Fläche 26d erstreckt, während wiederum für die Quantenstruktur 30e, die sich in der Fläche 26e erstreckt, der Abstand von der Quantenstruktur 30a etwas geringer ist, als das ganzzahlige Vielfache einer halben Wellenlänge.

Damit läßt sich in dem laseraktiven Volumenbereich 24 nicht nur erreichen, daß ein Laserverstärkerstrahlungsfeld 20 mit exakt der vorgegebenen Wellenlänge verstärkt wird, sondern auch Wellenlängen verstärkt werden, die von der exakt vorgegebenen Wellenlänge abweichen.

Bei den bislang beschriebenen Ausführungsbeispielen wurde, wie in Fig. 3 dargestellt, davon ausgegangen, daß die Anregung einer Quantenstruktur 30 in jeder der Flächen 26 so erfolgt, daß ein einheitlicher zusammenhängender Flächenbereich 88 optisch durch das Pumpstrahlungsfeld 70 gepumpt wird.

Alternativ dazu besteht bei einem sechsten, in Fig. 12 dargestellten Ausführungsbeispiel die Möglichkeit, die Quantenstruktur 30, beispielsweise ebenfalls die Quantenstruktur 30c, die sich in der Fläche 26c erstreckt, aber auch alle weiteren Quantenstrukturen 30 mit einem Pumpstrahlungsfeld 70' anzuregen, welches Strahlungsfeldsegmente 70'a, 70'b, 70'c und 70'd aufweist, die die Fläche 26 in voneinander getrennten Teilflächenbereichen 100a, 100b, 100c und 100d durchsetzen, so daß eine Anregung der sich im wesentlichen über den gesamten Querschnitt des Festkörpers 10 erstreckenden Quantenstruktur 30c lediglich in den Teilflächenbereichen 100a bis 100d erfolgt, während die zwischen diesen voneinander getrennten Teilflächenbereichen 100a bis 100d liegenden Bereiche der Quantenstruktur 30c nicht optisch gepumpt werden.

Dies schafft die Möglichkeit, in einfacher Weise die optische Verstärkung der in einer Fläche vorgesehenen Quantenstruktur 30 zu optimieren, ohne dabei die Ausdehnung eines optisch gepumpten Bereichs all zu groß werden zu lassen und somit eine unerwünschte optische Verstärkung in Richtung parallel zur Fläche 26 zu erhalten.

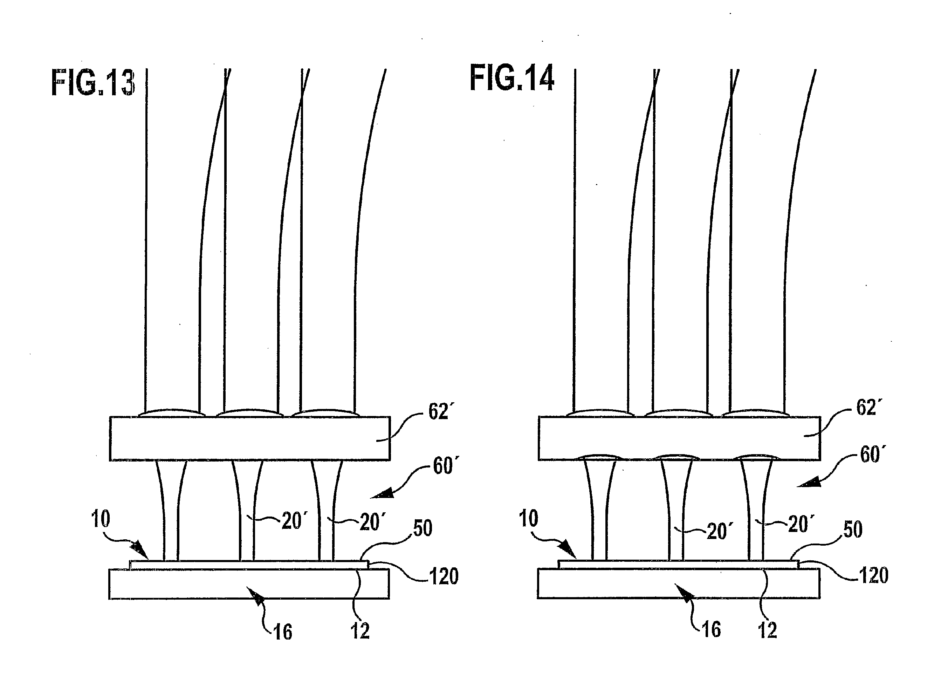

Die mit einem derartigen Pumpstrahlungsfeld 70' angeregten Quantenstrukturen 30 bilden somit einzelne Laserverstärkerstrahlungsfelder 20' aus, die, wie in Fig. 13 dargestellt, unabhängig voneinander sind.

Diese in Fig. 13 dargestellten Laserverstärkerstrahlungsfelder können jedoch durch externe Kopplungsmaßnahmen, beispielsweise teildurchlässige Spiegel und Verwendung eines der Laserverstärkerstrahlungsfelder 20' als Masterstrahlungsfeld, miteinander gekoppelt werden.

Alternativ zum Vorsehen einer externen Kopplung sieht eine interne Kopplung vor, daß die einzelnen Laserverstärkerstrahlungsfelder 20', die von den einzelnen optisch angeregten Flächenbereichen 100a bis 100c der Quantenstruktur 30c verstärkt werden, durch eine geeignete Verstärkeroptik 60', beispielsweise in Form eines Talbot-Resonators zu einem kohärenten Ausgangsstrahlungsfeld 102 zusammengefasst werden, wie in Fig. 14 dargestellt.

Ein derartiger Talbot-Resonator ist beispielsweise im Artikel von Uwe Brauch, P. Loosen, H. Opower, "High-Power Diode Lasers for Direct Applications" in: R.Diehl (ed.), High-Power Diode Lasers, Topics Appl. Phys. 78, Springer-Verlag, Berlin Heidelberg, 2000, pp. 303-367 im Zusammenhang mit Fig. 37 beschrieben.

Ein derartiges Strahlungsfeldsegmente 70'a bis 70'd umfassendes Pumpstrahlungsfeld 70' läßt sich entweder durch eine einzige Pumpstrahlungsquelle und Aufteilung von deren Strahlung oder mehrere Pumpstrahlungsquellen erzeugen. Vorzugsweise wird zur Bildung des Pumpstrahlungsfeldes 70 das Licht über Lichtleiter geführt und deren austrittsseitige Enden werden entsprechend der gewünschten Anordnung der Strahlungsfeldsegmente 70'a bis 70'd relativ zueinander positioniert, um insgesamt das Pumpstrahlungsfeld 70' zu erhalten.

Die Ausbildung des Festkörpers 10 und der Quantenstrukturen 30 kann im übrigen in gleicher Weise wie bei den voranstehenden Ausführungsbeispielen erfolgen, so daß hierauf nicht im einzelnen eingegangen wird, sondern vollinhaltlich auf die voranstehenden Ausführungen Bezug genommen wird.

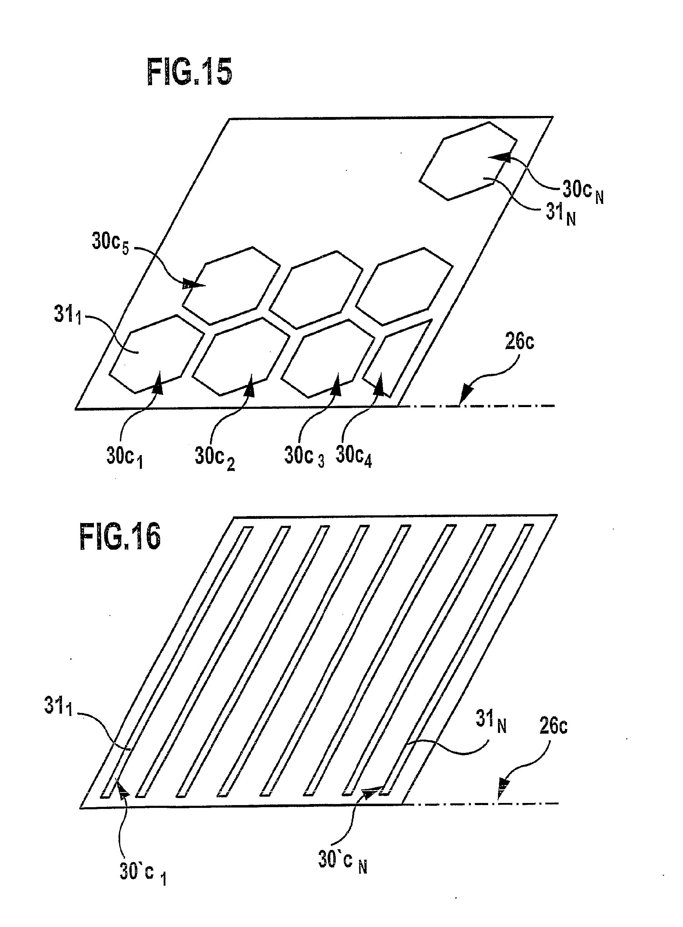

Bei einem siebten Ausführungsbeispiel eines erfindungsgemäßen Laserverstärkersystems, dargestellt in Fig. 15, ist in jeder der Flächen, in Fig. 15 exemplarisch der Fläche 26c, nicht eine zusammenhängende Quantenstruktur 30c vorgesehen, sondern eine Vielzahl von einzelnen Quantenstrukturen 30₁ bis 30_{N}, in diesem Fall 30c₁ bis 30c_{N}, die alle voneinander getrennte einzelne Teilflächenbereiche 31₁ bis 31_{N} der Fläche 26c überdecken.

In dem in Fig. 15 dargestellten siebten Ausführungsbeispiel sind die einzelnen, in der jeweiligen Fläche 26 angeordneten Quantenstrukturen 30₁ bis 30_{N} nach wie vor flächige Quantenstrukturen, das heißt Quantenfilme, so daß das in diesen vorhandenen Elektronengas nach wie vor ein zweidimensionales Elektronengas ist.

Derartige flächige Quantenstrukturen 30₁ bis 30_{N} in der jeweiligen Fläche 26 lassen sich beispielsweise durch geeignete Materialzusammensetzung in den Teilflächenbereichen 31₁ bis 31_{N} erreichen.

Bei einem achten Ausführungsbeispiel, dargestellt in Fig. 16, ist in jeder der Flächen 26 ebenfalls eine Vielzahl von Quantenstrukturen 30'₁ bis 30'_{N} in der vorliegenden Abbildung 30'c₁ bis 30'c_{N} vorgesehen. In diesem Fall sind die Quantenstrukturen 30'₁ bis 30'_{N} aber keine flächenhaften Quantenstrukturen, sondern sogenannte Quantendrähte, in denen kein zweidimensionales Elektronengas mehr vorliegt, sondern nur noch ein eindimensionales, nämlich in Längsrichtung des jeweiligen Quantendrahts 30'₁ bis 30'_{N}.

Auch derartige Quantendrähte 30₁ bis 30_{N} lassen sich vorzugsweise durch eine geeignete Dotierung in den Teilflächenbereichen 31₁ bis 31_{N} der jeweiligen Fläche 26 erreichen.

Vorzugsweise weisen dabei die Quantendrähte 30₁ bis 30_{N} in einer Richtung quer zu ihrer Längsrichtung eine Breite auf, die in der Größenordnung von deren Dicke senkrecht zur Fläche 26 liegt.

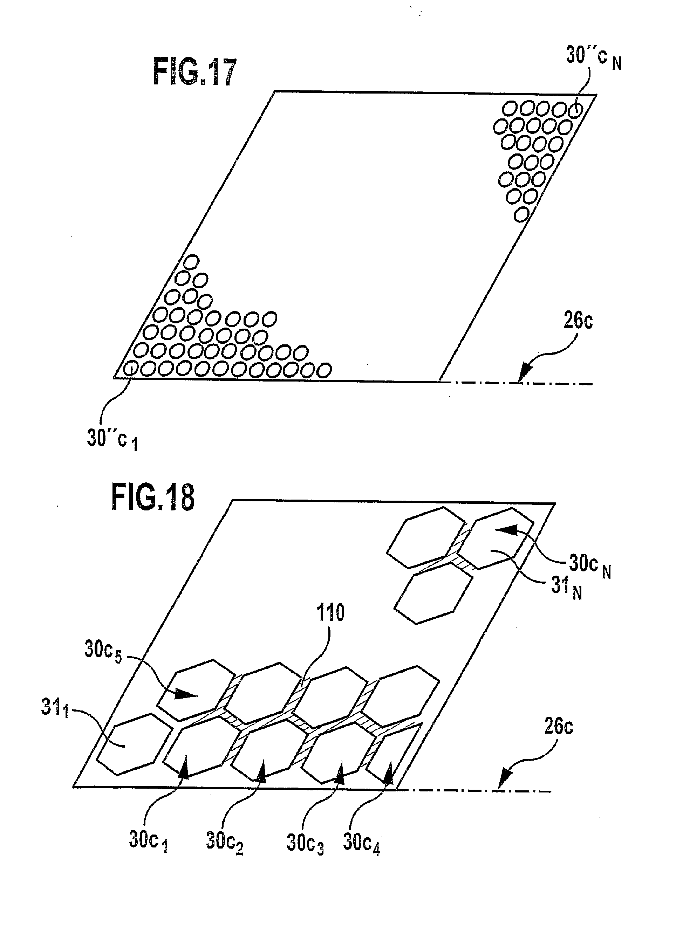

Bei einem neunten, in Fig. 17 dargestellten Ausführungsbeispiel sind die in der jeweiligen Fläche 26, beispielsweise der Fläche 26c, vorgesehenen Quantenstrukturen 30"₁ bis 30"_{N}, beispielsweise die in Fig. 17 dargestellten Quantenstrukturen 30"c₁ bis 30"c_{N}, weder Quantenfilme noch Quantendrähte, sondern sogenannte Quantenpunkte, in denen ein sogenanntes nulldimensionales Elektronengas vorliegt, wobei diese Quantenpunkte in der jeweiligen Fläche 26 maximale Ausdehnungen aufweisen, die in der Größenordnung von deren Dicke quer zur Fläche 26 liegt.

Bei dem siebten, achten und neunten Ausführungsbeispiel wird insoweit, als die übrigen Merkmale der Quantenstrukturen 30, der Festkörper 10, der Führung des Laserverstärkerstrahlungsfeldes 20 und des Pumpstrahlungsfeldes 70 betroffen sind, vollinhaltlich auf die Ausführungen zu den voranstehenden Ausführungsbeispielen Bezug genommen.

Ein zehntes, in Fig. 18 dargestelltes Ausführungsbeispiel basiert auf dem Ausführungsbeispiel gemäß Fig. 15, wobei bei diesem die Zwischenräume 110 zwischen den einzelnen Quantenstrukturen 30₁ bis 30_{N}, in diesem Fall den Quantenstrukturen 30c₁bis 30c_{N}, ein stark absorbierendes Material als Barriere 114 aufweisen, um somit eine Verstärkung in einer Richtung parallel zu der Fläche 26 zu vermeiden.

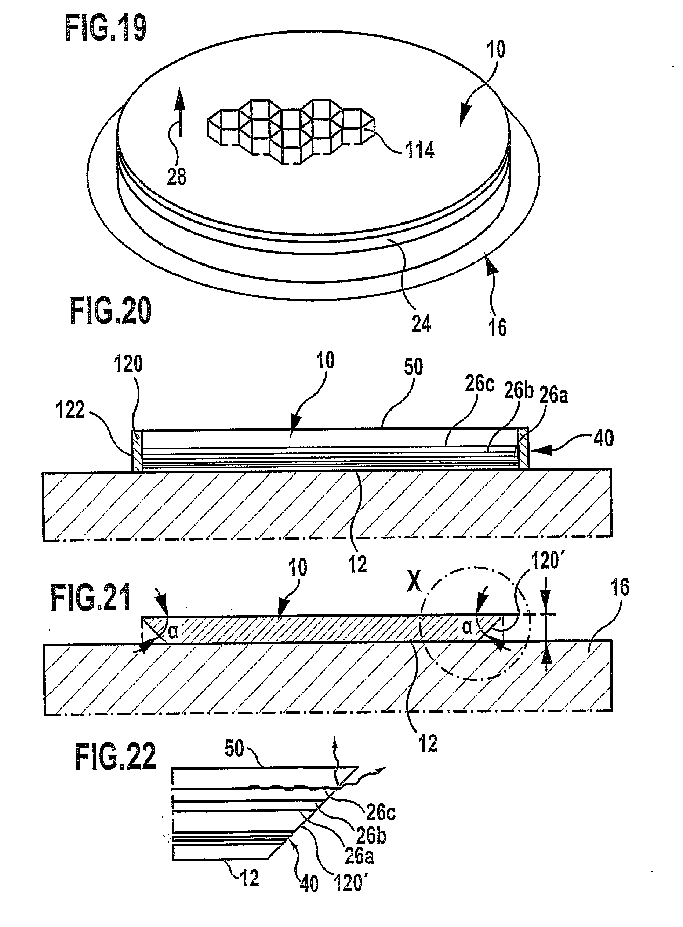

Vorzugsweise ist dabei, wie in Fig. 19 dargestellt, vorgesehen, daß das stark Strahlung bei der Wellenlänge des Laserverstärkerstrahlungsfeldes 20 absorbierende Material in den Zwischenräumen 110 Barrierewände 114 bildet, die sich zumindest über die Ausdehnung des laseraktiven Volumenbereichs 24 in Richtung der Stapelrichtung 28 erstrecken und somit auch im Bereich beispielsweise der Umgebungsstrukturen 34 die Ausbildung eines Verstärkerstrahlungsfeldes in Richtung parallel zur Fläche 26 verhindern.

Auch hinsichtlich des zehnten Ausführungsbeispiels wird hinsichtlich der übrigen Merkmale auf die voranstehenden Ausführungsbeispiele Bezug genommen.

Generell ist vorzugsweise bei einem elften, in Fig. 20 dargestellten Ausführungsbeispiel vorgesehen, daß zur Unterdrückung der Ausbildung eines Verstärkerstrahlungsfeldes in Richtung parallel zu den jeweiligen Flächen 26 der Festkörper 10 im Bereich seiner sich zwischen der Kühlfläche 12 und der Austrittsfläche 50 verlaufenden Seitenflächen 120 mit einer Antireflexschicht 122 versehen ist, die den ganzen Festkörper 10 im Bereich der Seitenflächen 120 umschließt und verhindert, daß sich in Richtung der Flächen 26 ausbreitende Strahlung zurückreflektiert und somit erneut verstärkt wird.

Alternativ dazu ist bei einem zwölften Ausführungsbeispiel, dargestellt in Fig. 21 und 22, vorgesehen, daß anstelle der Antireflexschicht 122 die Seitenfläche 120' gegenüber den Flächen 26 in einem Winkel α verläuft, welcher dem Winkel maximaler Auskopplung für Licht der Wellenlänge des Laserverstärkerstrahlungsfeldes 20 entspricht, so daß sich parallel zu den Flächen 26 ausbreitendes Licht im Bereich der Seitenflächen 120' ebenfalls nicht zurückreflektiert wird, sondern aus dem Festkörper 10 austritt und somit ebenfalls eine resonante Verstärkung von sich parallel zu den Flächen 26 ausbreitender Strahlung vermieden werden kann.

Auch hinsichtlich der weiteren Merkmale des elften und zwölften Ausführungsbeispiels wird auf die Ausführungen zu den voranstehenden Ausführungsbeispielen Bezug genommen.

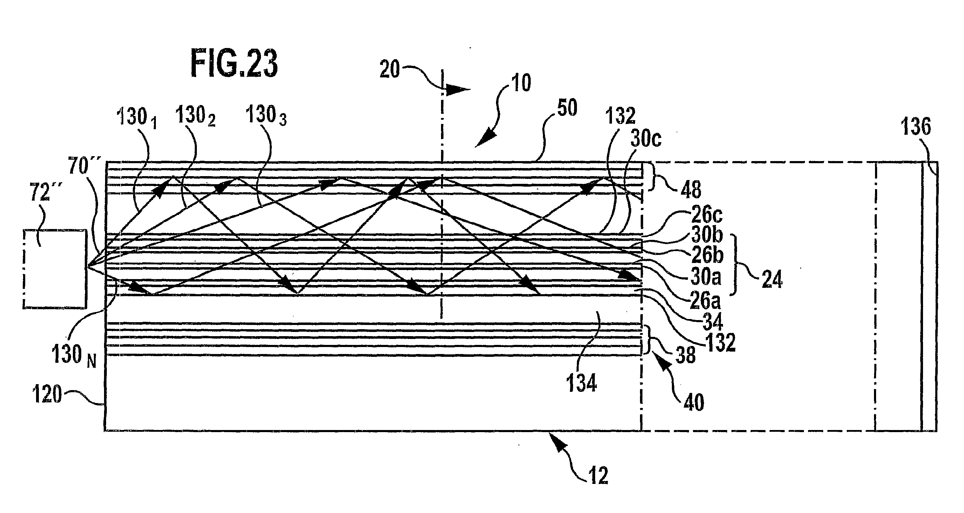

Bei einem dreizehnten, in Fig. 23 dargestellten Ausführungsbeispiel ist die Pumpstrahlungsquelle 72" nicht so angeordnet, daß das Pumpstrahlungsfeld 70' über die Austrittsfläche 50 für das Laserverstärkerstrahlungsfeld 20 in den Festkörper 10 eintritt, sondern so angeordnet, daß das Pumpstrahlungsfeld 70" über die Seitenfläche 120 des Festkörpers 10 in diesen eintritt, und zwar vorzugsweise so, daß dies im Bereich des laseraktiven Volumenbereichs 24 erfolgt.

Dabei wird davon ausgegangen, daß das Pumpstrahlungsfeld 70" eine Divergenz aufweist, so daß die Pumpstrahlung mit Ausbreitungsrichtungen 130₁ bis 130_{N} in den Festkörper 10 eintritt, die in unterschiedlichen spitzen Winkeln zu den Ebenen 26 verlaufen, in welchen sich die Quantenstrukturen 30 erstrecken.

Das Pumpstrahlungsfeld 70" wird dabei in einer Richtung parallel zu den Flächen 26 im Festkörper 10 dadurch geführt, daß das Pumpstrahlungsfeld 70" einerseits nahe der Austrittsfläche 50 durch den antireflektierenden Volumenbereich 48 total reflektiert wird und andererseits an einer Grenzfläche 132 zu einer Zwischenschicht 134 reflektiert wird, die zwischen dem laseraktiven Volumenbereich 24 und dem reflektierenden Volumenbereich 38 angeordnet ist und einen Brechungsindex aufweist, der geringer ist als der Brechungsindex in der an die Grenzfläche 132 angrenzenden Umgebungsstruktur 34 des laseraktiven Volumenbereichs 24.

Durch die Reflexionen des Pumpstrahlungsfeldes 70" mit der sich in den unterschiedlichen Ausbreitungsrichtungen 130₁ bis 130_{N} ausbreitenden Pumpstrahlung an dem antireflektierenden Volumenbereich 48 und der Grenzfläche 132 der Zwischenschicht 134 entsteht zumindest in ausreichendem Abstand von der Seitenfläche 120, beispielsweise in einem Flächenbereich 132 der Flächen 26, ein Mehrfachpumpen der Quantenstrukturen 30 aufgrund der Tatsache, daß sich das Pumpstrahlungsfeld 70" in einer Vielzahl von Ausbreitungsrichtungen 130₁ bis 130_{N} mit jeweils unterschiedlichen Winkeln zu den Flächen 26 ähnlich einer Multimodewellenleitung ausbreitet, insbesondere dann, wenn das Pumpstrahlungsfeld 70" im Bereich einer der Pumpstrahlungsquelle 72" gegenüberliegenden Seite angeordneten Reflexionsschicht 136 wieder in Richtung der Pumpstrahlungsquelle 72" zurückreflektiert wird.

Im übrigen können bei diesem Ausführungsbeispiel die Quantenstrukturen 30 entsprechend allen vorstehend beschriebenen Ausführungsbeispielen ausgebildet sein.

Auch beim dreizehnten Ausführungsbeispiel wird hinsichtlich der Merkmale der betreffend die Ausbildung der Quantenstrukturen 30 des Festkörpers 10 und der Führung des Laserverstärkerstrahlungsfeldes 20 vollinhaltlich auf die Ausführungen zu den voranstehenden Ausführungsbeispielen Bezug genommen.

## Patentansprüche

1. Laserverstärkersystem umfassend einen mit einem Kühlkörper (16) thermisch gekoppelten Festkörper (10) mit einem laseraktiven Volumenbereich (24), in welchem in mindestens einer Fläche (26) mindestens eine sich zumindest über Teilbereiche der Fläche erstreckende laseraktive Quantenstruktur (30) aus Halbleitermaterial angeordnet ist, eine ein Pumpstrahlungsfeld (70) erzeugende Pumpstrahlungsquelle (72) zum optischen Pumpen des laseraktiven Volumenbereichs (24) und eine ein den laseraktiven Volumenbereich (24) durchsetzendes Laserverstärkerstrahlungsfeld (20) definierende Verstärkeroptik (60),
**dadurch gekennzeichnet, dass**
- der laseraktive Volumenbereich (24) mehrere, in einer Stapelrichtung (28) im Abstand voneinander, jedoch in übereinander angeordneten Flächen (26) liegende Quantenstrukturen (30) aufweist,
- die Quantenstrukturen (30) durch zwischen diesen liegenden Zwischenschichten (34) voneinander getrennt sind, wobei die Zwischenschichten ausschließlich aus Umgebungsstruktur aufgebaut sind,
- die Absorption von Pumpstrahlung aus dem Pumpstrahlungsfeld (70) in der laseraktiven Quantenstruktur (30) größer als die Absorption von Pumpstrahlung durch die an die Quantenstruktur (30) angrenzende Umgebungsstruktur ist und die Absorption von Pumpstrahlung aus dem Pumpstrahlungsfeld (70) in den Quantenstrukturen (30) größer als die Absorption von Pumpstrahlung durch die Zwischenschichten (34) ist, so dass die Pumpstrahlung überwiegend in den Quantenstrukturen (30) selbst absorbiert wird
- das Pumpstrahlungsfeld (70) so verläuft, dass es die Quantenstruktur (30) mehrfach durchsetzt,
- in jeder Fläche (26) mehrere nebeneinander angeordnete Quantenstrukturen (30₁ bis 30_{N}) vorgesehen sind,
- in Richtung quer zur Stapelrichtung (28) aufeinander folgend angeordnete Quantenstrukturen (30₁ bis 30_{N}) optisch voneinander getrennt sind,
- die Quantenstrukturen (30₁ bis 30_{N}) durch Barrieren (114) aus optisch absorbierenden Materialien voneinander getrennt sind, wobei die absorbierenden Materialien hauptsächlich im Wellenlängenbereich des Laserverstärkerstrahlungsfelds der Quantenstrukturen absorbieren und
- das Pumpstrahlungsfeld (70) gleichzeitig nicht zusammenhängende Teilflächenbereiche (100) der Fläche (26) durchsetzt, in der die Quantenstrukturen (30₁ bis 30_{N}) angeordnet sind, und die innerhalb dieser Teilflächenbereiche (100) vorhandenen Quantenstrukturen (30₁ bis 30_{N}) optisch pumpt.

2. Laserverstärkersystem nach dem vorherigen Anspruch,
**dadurch gekennzeichnet, dass**
die Absorption von Pumpstrahlung in der mindestens einen Quantenstruktur (30) die Absorption von Pumpstrahlung in den Volumenbereichen des Festkörpers (10) außerhalb der Quantenstruktur (30) überwiegt.

3. Laserverstärkersystem nach einem der voranstehenden Ansprüche,
**dadurch gekennzeichnet, dass**
die Umgebungsstruktur aus einem Halbleitermaterial gebildet ist.

4. Laserverstärkersystem nach dem vorherigen Anspruch,
**dadurch gekennzeichnet, dass**
die Umgebungsstruktur durch Schichten aus Halbleitermaterial gebildet ist.

5. Laserverstärkersystem nach Anspruch 3 oder 4,
**dadurch gekennzeichnet, dass**
das Halbleitermaterial der Quantenstruktur (30) einen geringeren Bandabstand aufweist als die Umgebungsstruktur.

6. Laserverstärkersystem nach einem der voranstehenden Ansprüche,
**dadurch gekennzeichnet, dass**
jede Umgebungsstruktur quer zu der Fläche (26) eine Dicke aufweist, die ein Mehrfaches der Dicke der Quantenstruktur (30) beträgt.

7. Laserverstärkersystem nach einem der voranstehenden Ansprüche,
**dadurch gekennzeichnet, dass**
die Umgebungsstruktur quer zu der Fläche (26) eine Dicke aufweist, die mindestens 10 nm beträgt.

8. Laserverstärkersystem nach dem vorherigen Anspruch,
**dadurch gekennzeichnet, dass**
die Umgebungsstruktur quer zu der Fläche (26) eine Dicke aufweist, die mindestens 30 nm beträgt.

9. Laserverstärkersystem nach einem der voranstehenden Ansprüche,
**dadurch gekennzeichnet, dass**
das Laserverstärkerstrahlungsfeld (20) quer zu der Fläche (26) verläuft, in welcher sich die Quantenstruktur (30) erstreckt.

10. Laserverstärkersystem nach einem der voranstehenden Ansprüche,
**dadurch gekennzeichnet, dass** das Laserverstärkerstrahlungsfeld (20) ungefähr in Richtung der Stapelrichtung (28) durch die Quantenstrukturen (30) verläuft.

11. Laserverstärkersystem nach dem vorherigen Anspruch,
**dadurch gekennzeichnet, dass**
bei mindestens einem Teil der Quantenstrukturen (30) diese in der Stapelrichtung (28) Abstände (A) aufweisen, die ungefähr der halben Wellenlänge oder einem ganzzahligen Vielfachen der halben Wellenlänge des Laserverstärkerstrahlungsfeldes (20) bei optimaler Laserverstärkung entsprechen.

12. Laserverstärkersystem nach dem vorherigen Anspruch,
**dadurch gekennzeichnet, dass**
die Abstände (A) der Quantenstrukturen (30) in thermodynamischem Gleichgewichtszustand bei Laserverstärkung des laseraktiven Volumenbereichs (24) ungefähr der halben Wellenlänge oder dem ganzzahligen Vielfachen der halben Wellenlänge der optimalen Laserverstärkung entsprechen.

13. Laserverstärkersystem nach einem der voranstehenden Ansprüche,
**dadurch gekennzeichnet, dass**
sich die Fläche (26), in der die Quantenstruktur (30) angeordnet ist, ungefähr parallel zu einer äußeren Kühlfläche (12) des Festkörpers erstreckt.

14. Laserverstärkersystem nach einem der voranstehenden Ansprüche,
**dadurch gekennzeichnet, dass**
sich die Fläche (26), in der die Quantenstruktur (30) angeordnet ist, ungefähr parallel zu einer Austrittsfläche (50) für das Laserverstärkerstrahlungsfeld (20) erstreckt.

15. Laserverstärkersystem nach dem vorherigen Anspruch,
**dadurch gekennzeichnet, dass**
zwischen der Austrittsfläche (50) für das Laserverstärkerstrahlungsfeld (20) und der Fläche (26), in der sich die Quantenstruktur (30) erstreckt, eine optisch inaktive Schicht (34) mit einer Dicke liegt, die ein mehrfaches der Wellenlänge des Laserverstärkerstrahlungsfeldes beträgt.

16. Laserverstärkersystem nach einem der voranstehenden Ansprüche,
**dadurch gekennzeichnet, dass**
die Quantenstruktur (30) eine Dicke aufweist, die so gering ist, dass durch diese eine Vergrößerung der Zustandsdichte an der Bandkante eintritt.

17. Laserverstärkersystem nach einem der voranstehenden Ansprüche,
**dadurch gekennzeichnet, dass**
die Quantenstruktur (30) eine Dicke aufweist, die ungefähr in der Größenordnung der Wellenlänge der Elektronen im Material der Quantenstruktur ist.

18. Laserverstärkersystem nach einem der voranstehenden Ansprüche,
**dadurch gekennzeichnet, dass**
die Quantenstruktur (30) quer zu der Fläche (26) eine Dicke von weniger als 20 nm aufweist.

19. Laserverstärkersystem nach einem der voranstehenden Ansprüche,
**dadurch gekennzeichnet, dass**
die Quantenstruktur (30) als Quantenfilm ausgebildet ist.

20. Laserverstärkersystem nach einem der voranstehenden Ansprüche,
**dadurch gekennzeichnet, dass**
die Quantenstruktur (30) aus Quantendrähten ausgebildet ist.

21. Laserverstärkersystem nach einem der voranstehenden Ansprüche,
**dadurch gekennzeichnet, dass**
die Quantenstruktur (30) aus Quantenpunkten ausgebildet ist.

22. Laserverstärkersystem nach einem der voranstehenden Ansprüche,
**dadurch gekennzeichnet, dass**
der Festkörper (10) auf einer Seite des laseraktiven Volumenbereichs (24), einen Reflektor (40) für das Laserverstärkerstrahlungsfeld (20) aufweist.

23. Laserverstärkersystem nach dem vorherigen Anspruch,
**dadurch gekennzeichnet, dass**
der Reflektor (40) ein im Festkörper (10) angeordneter interner Reflektor ist.

24. Laserverstärkersystem nach dem vorherigen Anspruch,
**dadurch gekennzeichnet, dass**
der interne Reflektor (40) durch eine Folge von Schichten (42) gebildet ist.

25. Laserverstärkersystem nach Anspruch 23 oder 24,
**dadurch gekennzeichnet, dass**
der Festkörper (10) auf einer Seite des laseraktiven Volumenbereichs (24) mit einem den internen Reflektor (40) bildenden reflektierenden Volumenbereich (38) versehen ist.

26. Laserverstärkersystem nach dem vorherigen Anspruch,
**dadurch gekennzeichnet, dass**
der reflektierende Volumenbereich einen als Braggreflektor (40) ausgebildeten Bereich aufweist.

27. Laserverstärkersystem nach einem der Ansprüche 22 bis 26,
**dadurch gekennzeichnet, dass**
der interne Reflektor (40, 80) in einem Abstand von der Kühlfläche (12) angeordnet ist, der weniger als 100 µm beträgt.

28. Laserverstärkersystem nach einem der voranstehenden Ansprüche,
**dadurch gekennzeichnet, dass**
das Pumpstrahlungsfeld (70) den laseraktiven Volumenbereich (24) in einer quer zu der Fläche (26), in der sich die Quantenstruktur (30) erstreckt, verlaufenden Richtung mehrfach durchsetzt.

29. Laserverstärkersystem nach dem vorherigen Anspruch,
**dadurch gekennzeichnet, dass**
das Pumpstrahlungsfeld (70) dieselbe Oberfläche (50) des Festkörpers (10) durchsetzt wie das Laserverstärkerstrahlungsfeld.

30. Laserverstärkersystem nach dem vorherigen Anspruch,
**dadurch gekennzeichnet, dass**
die Oberfläche (50) der Kühlfläche (14) gegenüberliegend angeordnet ist.

31. Laserverstärkersystem nach einem der voranstehenden Ansprüche,
**dadurch gekennzeichnet, dass**
sich die Fläche (26), in der die Quantenstruktur (30) angeordnet ist, ungefähr parallel zu einer Durchtrittsfläche (50) des Festkörpers (10) für das Pumpstrahlungsfeld (70) erstreckt.

32. Laserverstärkersysteme nach einem der voranstehenden Ansprüche,
**dadurch gekennzeichnet, dass**
der Festkörper (10) auf einer Seite des laseraktiven Volumenbereichs (24) mit einem Reflektor (80) für das Pumpstrahlungsfeld (70) versehen ist.

33. Laserverstärkersystem nach dem vorherigen Anspruch,
**dadurch gekennzeichnet, dass**
der Reflektor (80) ein im Festkörper (10) angeordneter Reflektor (80) ist.

34. Laserverstärkersystem nach dem vorherigen Anspruch,
**dadurch gekennzeichnet, dass**
der interne Reflektor (80) durch eine Folge von Schichten (42) gebildet ist.

35. Laserverstärkersystem nach Anspruch 33 oder 34,
**dadurch gekennzeichnet, dass**
der interne Reflektor (80) für das Pumpstrahlungsfeld (70) durch einen reflektierenden Volumenbereich (38) gebildet ist.

36. Laserverstärkersystem nach dem vorherigen Anspruch,
**dadurch gekennzeichnet, dass**
der reflektierende Volumenbereich (38) einen als Braggreflektor ausgebildeten Bereich umfasst.

37. Laserverstärkersystem nach einem der Ansprüche 22 bis 36,
**dadurch gekennzeichnet, dass**
der Reflektor (40) für das Laserverstärkerstrahlungsfeld (20) und der Reflektor (80) für das Pumpstrahlungsfeld (70) zu einem Reflektor (40) zusammengefasst sind.

38. Laserverstärkersystem nach dem vorherigen Anspruch,
**dadurch gekennzeichnet, dass**
der Reflektor (40) durch eine Folge von Schichten (42) gebildet ist, deren Aufbau und Anordnung hinsichtlich der Wellenlänge und des Einfallswinkels des Laserverstärkerstrahlungsfeldes (20) und der Wellenlänge und des Einfallswinkels des Pumpstrahlungsfeldes (70) optimiert ist.

39. Laserverstärkersystem nach einem der voranstehenden Ansprüche,
**dadurch gekennzeichnet, dass**
die Quantenstruktur (30) quer zur Stapelrichtung (28) eine Ausdehnung aufweist, die geringer ist als die des Festkörpers (10) in dieser Richtung.

40. Laserverstärkersystem nach einem der voranstehenden Ansprüche,
**dadurch gekennzeichnet, dass**
in jeder Fläche (26) eine Quantenstruktur (30) vorgesehen ist.

41. Laserverstärkersystem nach einem der voranstehenden Ansprüche,
**dadurch gekennzeichnet, dass**
das Pumpstrahlungsfeld (70) die Fläche (26), in welcher sich die jeweilige Quantenstruktur (30) erstreckt, in einem Flächenbereich (88a, b) durchsetzt, welcher kleiner als die Ausdehnung der Quantenstruktur (30) in Richtung der Fläche (26) ist.

42. Laserverstärkersystem nach dem vorherigen Anspruch,
**dadurch gekennzeichnet, dass**
das Pumpstrahlungsfeld (70) bei jedem Durchgang durch die Fläche (26), in welcher die Quantenstruktur (30) angeordnet ist, einen Flächenbereich (88a, 88b) durchsetzt und dass die Summe der Flächenbereiche (88a, b) einen zusammenhängenden Anregungsbereich (88) ergibt.

43. Laserverstärkersystem nach dem vorherigen Anspruch,
**dadurch gekennzeichnet, dass**
das Pumpstrahlungsfeld (70) nicht zusammenhängende Pumpstrahlungsfeldsegmente (70'a bis d) aufweist, von denen jedes mindestens einen der Teilflächenbereiche (100) durchsetzt.

44. Laserverstärkersystem nach dem vorherigen Anspruch,
**dadurch gekennzeichnet, dass**
die Quantenstrukturen (30₁ bis 30_{N}) von Barrieren (114) aus optisch absorbierenden Materialien umschlossen sind.

45. Laserverstärkersystem nach dem vorherigen Anspruch,
**dadurch gekennzeichnet, dass**
die Barrieren (114) aus optisch absorbierenden Materialien in den Flächen (26), in denen die Quantenstrukturen (30) liegen, eine geschlossene Kontur bilden.

46. Laserverstärkersystem nach einem der voranstehenden Ansprüche,
**dadurch gekennzeichnet, dass**
der Festkörper (10) auf einer Seite des laseraktiven Volumenbereichs (24) für das Laserverstärkerstrahlungsfeld (20) antireflektierende ausgebildet ist.

47. Laserverstärkersystem nach dem vorherigen Anspruch,
**dadurch gekennzeichnet, dass**
der Festkörper (10) auf einer Seite des laseraktiven Volumenbereichs (24) mit einem antireflektierenden Volumenbereich (48) versehen ist.

48. Laserverstärkersystem nach Anspruch 46 oder 47,
**dadurch gekennzeichnet, dass**
der antireflektierende Volumenbereich (48) und der den Reflektor (40, 80) bildende Volumenbereich (38) auf in Stapelrichtung (28) unterschiedlichen Seiten des laseraktiven Volumenbereichs (24) angeordnet sind.

49. Laserverstärkersystem nach einem der voranstehenden Ansprüche,
**dadurch gekennzeichnet, dass**
der Festkörper (10) auf einer Eintrittsseite des Pumpstrahlungsfeldes (70) antireflektierende ausgebildet ist.

50. Laserverstärkersystem nach dem vorherigen Anspruch,
**dadurch gekennzeichnet, dass**
der Festkörper (10) mit einem antireflektierenden Volumenbereich (48) versehen ist.

51. Laserverstärkersystem nach Anspruch 49 oder 50,
**dadurch gekennzeichnet, dass**
der Festkörper (10) auf einer Seite des laseraktiven Volumenbereichs (24) für das Pumpstrahlungsfeld (70) antireflektierend ausgebildet ist.

52. Laserverstärkersystem nach dem vorherigen Anspruch,
**dadurch gekennzeichnet, dass**
der antireflektierende Volumenbereich (48) und der den Reflektor (80) bildende Volumenbereich (38) auf in Stapelrichtung (28) unterschiedlichen Seiten des laseraktiven Volumenbereichs (24) angeordnet sind.

53. Laserverstärkersystem nach einem der voranstehenden Ansprüche,
**dadurch gekennzeichnet, dass**
das Pumpstrahlungsfeld (70') über eine Seitenfläche (120) in den Festkörper (10) eintritt.

54. Laserverstärkersystem nach dem vorherigen Anspruch,
**dadurch gekennzeichnet, dass**
das Pumpstrahlungsfeld (70') divergent in den Festkörper (10) eintritt und in diesem durch Reflexionen in Richtung quer zur optischen Achse (22) des Laserverstärkerstrahlungsfeldes (20) geführt ist.

55. Laserverstärkersystem nach dem vorherigen Anspruch,
**dadurch gekennzeichnet, dass**
die Reflexionen des Pumpstrahlungsfeldes (70') durch Brechungsindexgradienten und/oder Brechungsindexstufen im Festkörper (10) erfolgen.

56. Laserverstärkersystem nach einem der voranstehenden Ansprüche,
**dadurch gekennzeichnet, dass**
das Laserverstärkerstrahlungsfeld (20) durch eine Verstärkeroptik (60) definiert ist, die mindestens einen im Abstand von dem Festkörper (10) angeordneten externen Spiegel (62) umfasst.

57. Laserverstärkersystem nach einem der voranstehenden Ansprüche,
**dadurch gekennzeichnet, dass**
die Verstärkeroptik (60) so ausgebildet ist, dass sie nur ein Laserstrahlungsfeld (20) mit dem Grundmode oder mit dem Grundmode und grundmodenahen Moden zulässt.

## Claims

1. Laser amplifier system comprising a solid body (10) thermally coupled to a heat sink (16) and having a laser-active volume region (24), in which there is arranged in at least one area (26) at least one laser-active quantum structure (30) composed of a semiconductor material extending at least over partial regions of the area, a pump radiation source (72) generating a pump radiation field (70) and serving for optically pumping the laser-active volume region (24), and an amplifier optical unit (60) defining a laser amplifier radiation field (20) permeating the laser-active volume region (24),
**characterized in that**
- the laser-active volume region (24) has a plurality of quantum structures (30) lying at a distance from one another in a stacking direction (28), but in areas (26) arranged one above another,
- the quantum structures (30) are separated from one another by interlayers (34) lying between them, wherein the interlayers are constructed exclusively from surrounding structure,
- the absorption of pump radiation from the pump radiation field (70) in the laser-active quantum structure (30) is greater than the absorption of pump radiation by the surrounding structure adjoining the quantum structure (30), and the absorption of pump radiation from the pump radiation field (70) in the quantum structures (30) is greater than the absorption of pump radiation by the interlayers (34), such that the pump radiation is predominantly absorbed in the quantum structures (30) themselves,
- the pump radiation field (70) proceeds such that it multiply permeates the quantum structure (30),
- a plurality of quantum structures (30₁ to 30_{N}) arranged alongside one another are provided in each area (26),
- quantum structures (30₁ to 30_{N}) arranged successively in a direction transversely with respect to the stacking direction (28) are optically separated from one another,
- the quantum structures (30₁ to 30_{N}) are separated from one another by barriers (114) composed of optically absorbent materials, wherein the absorbent materials absorb principally in the wavelength range of the laser amplifier radiation field of the quantum structures, and
- the pump radiation field (70) simultaneously permeates non-continuous partial area regions (100) of the area (26) in which the quantum structures (30₁ to 30_{N}) are arranged, and optically pumps the quantum structures (30₁ to 30_{N}) present within said partial area regions (100).

2. Laser amplifier system according to the preceding claim,
**characterized in that**
the absorption of pump radiation in the at least one quantum structure (30) outweighs the absorption of pump radiation in the volume regions of the solid body (10) outside the quantum structure (30).

3. Laser amplifier system according to either of the preceding claims,
**characterized in that**
the surrounding structure is formed from a semiconductor material.

4. Laser amplifier system according to the preceding claim,
**characterized in that**
the surrounding structure is formed by layers composed of semiconductor material.

5. Laser amplifier system according to Claim 3 or 4,
**characterized in that**
the semiconductor material of the quantum structure (30) has a smaller band gap than the surrounding structure.

6. Laser amplifier system according to any of the preceding claims,
**characterized in that**
each surrounding structure has transversely with respect to the area (26) a thickness amounting to a multiple of the thickness of the quantum structure (30).

7. Laser amplifier system according to any of the preceding claims,
**characterized in that**
the surrounding structure has transversely with respect to the area (26) a thickness amounting to at least 10 nm.

8. Laser amplifier system according to the preceding claim,
**characterized in that**
the surrounding structure has transversely with respect to the area (26) a thickness amounting to at least 30 nm.

9. Laser amplifier system according to any of the preceding claims,
**characterized in that**
the laser amplifier radiation field (20) proceeds transversely with respect to the area (26) in which the quantum structure (30) extends.

10. Laser amplifier system according to any of the preceding claims,
**characterized in that**
the laser amplifier radiation field (20) proceeds approximately in the direction of the stacking direction (28) through the quantum structures (30).

11. Laser amplifier system according to the preceding claim,
**characterized in that**
in the case of at least one portion of the quantum structures (30), the latter have in the stacking direction (28) spacings (A) corresponding to approximately half the wavelength or an integral multiple of half the wavelength of the laser amplifier radiation field (20) in the case of optimum laser amplification.

12. Laser amplifier system according to the preceding claim,
**characterized in that**
the spacings (A) of the quantum structures (30) in a thermodynamic equilibrium state in the case of laser amplification of the laser-active volume region (24) correspond to approximately half the wavelength or the integral multiple of half the wavelength of the optimum laser amplification.

13. Laser amplifier system according to any of the preceding claims,
**characterized in that**
the area (26) in which the quantum structure (30) is arranged extends approximately parallel to an outer cooling area (12) of the solid body.

14. Laser amplifier system according to any of the preceding claims,
**characterized in that**
the area (26) in which the quantum structure (30) is arranged extends approximately parallel to an exit area (50) for the laser amplifier radiation field (20).

15. Laser amplifier system according to the preceding claim,
**characterized in that**
an optically inactive layer (34) having a thickness amounting to a multiple of the wavelength of the laser amplifier radiation field lies between the exit area (50) for the laser amplifier radiation field (20) and the area (26) in which the quantum structure (30) extends.

16. Laser amplifier system according to any of the preceding claims,
**characterized in that**
the quantum structure (30) has a thickness which is so small that it results in an increase in the density of states at the band edge.

17. Laser amplifier system according to any of the preceding claims,
**characterized in that**
the quantum structure (30) has a thickness which is approximately of the order of magnitude of the wavelength of the electrons in the material of the quantum structure.

18. Laser amplifier system according to any of the preceding claims,
**characterized in that**
the quantum structure (30) has transversely with respect to the area (26) a thickness of less than 20 nm.

19. Laser amplifier system according to any of the preceding claims,
**characterized in that**
the quantum structure (30) is embodied as a quantum film.

20. Laser amplifier system according to any of the preceding claims,
**characterized in that**
the quantum structure (30) is formed from quantum wires.

21. Laser amplifier system according to any of the preceding claims,
**characterized in that**
the quantum structure (30) is formed from quantum dots.

22. Laser amplifier system according to any of the preceding claims,
**characterized in that**
the solid body (10) has on a side of the laser-active volume region (24) a reflector (40) for the laser amplifier radiation field (20).

23. Laser amplifier system according to the preceding claim,
**characterized in that**
the reflector (40) is an internal reflector arranged in the solid body (10).

24. Laser amplifier system according to the preceding claim,
**characterized in that**
the internal reflector (40) is formed by a sequence of layers (42).

25. Laser amplifier system according to Claim 23 or 24,
**characterized in that**
the solid body (10), on a side of the laser-active volume region (24), is provided with a reflective volume region (38) forming the internal reflector (40).

26. Laser amplifier system according to the preceding claim,
**characterized in that**
the reflective volume region has a region embodied as a Bragg reflector (40).

27. Laser amplifier system according to any of Claims 22 to 26,
**characterized in that**
the internal reflector (40, 80) is arranged at a distance from the cooling area (12) that amounts to less than 100 µm.

28. Laser amplifier system according to any of the preceding claims,
**characterized in that**
the pump radiation field (70) multiply permeates the laser-active volume region (24) in a direction running transversely with respect to the area (26) in which the quantum structure (30) extends.

29. Laser amplifier system according to the preceding claim,
**characterized in that**
the pump radiation field (70) permeates the same surface (50) of the solid body (10) as the laser amplifier radiation field.

30. Laser amplifier system according to the preceding claim,
**characterized in that**
the surface (50) is arranged opposite the cooling area (14).

31. Laser amplifier system according to any of the preceding claims,
**characterized in that**
the area (26) in which the quantum structure (30) is arranged extends approximately parallel to a passage area (50) of the solid body (10) for the pump radiation field (70).

32. Laser amplifier system according to any of the preceding claims,
**characterized in that**
the solid body (10), on a side of the laser-active volume region (24), is provided with a reflector (80) for the pump radiation field (70).

33. Laser amplifier system according to the preceding claim,
**characterized in that**
the reflector (80) is a reflector (80) arranged in the solid body (10).

34. Laser amplifier system according to the preceding claim,
**characterized in that**
the internal reflector (80) is formed by a sequence of layers (42).

35. Laser amplifier system according to Claim 33 or 34,
**characterized in that**
the internal reflector (80) for the pump radiation field (70) is formed by a reflective volume region (38).

36. Laser amplifier system according to the preceding claim,
**characterized in that**
the reflective volume region (38) comprises a region embodied as a Bragg reflector.

37. Laser amplifier system according to any of Claims 22 to 36,
**characterized in that**
the reflector (40) for the laser amplifier radiation field (20) and the reflector (80) for the pump radiation field (70) are combined to form one reflector (40).

38. Laser amplifier system according to the preceding claim,
**characterized in that**
the reflector (40) is formed by a sequence of layers (42) whose construction and arrangement are optimized with regard to the wavelength and the angle of incidence of the laser amplifier radiation field (20) and the wavelength and the angle of incidence of the pump radiation field (70).

39. Laser amplifier system according to any of the preceding claims,
**characterized in that**
the quantum structure (30) has transversely with respect to the stacking direction (28) an extent which is smaller than that of the solid body (10) in this direction.

40. Laser amplifier system according to any of the preceding claims,
**characterized in that**
a quantum structure (30) is provided in each area (26).

41. Laser amplifier system according to any of the preceding claims,
**characterized in that**
the pump radiation field (70) permeates the area (26) in which the respective quantum structure (30) extends in an area region (88a, b) which is smaller than the extent of the quantum structure (30) in the direction of the area (26).

42. Laser amplifier system according to the preceding claim,
**characterized in that**
the pump radiation field (70) permeates an area region (88a, 88b) upon each occurrence of passing through the area (26) in which the quantum structure (30) is arranged, and **in that** the sum of the area regions (88a, b) produces a continuous excitation region (88).

43. Laser amplifier system according to the preceding claim,
**characterized in that**
the pump radiation field (70) has non-continuous pump radiation field segments (70'a to d), each of which permeates at least one of the partial area regions (100).

44. Laser amplifier system according to the preceding claim,
**characterized in that**
the quantum structures (30₁ to 30_{N}) are enclosed by the barriers (114) composed of optically absorbent materials.

45. Laser amplifier system according to the preceding claim,
**characterized in that**
the barriers (114) composed of optically absorbent materials form a closed contour in the areas (26) in which the quantum structures (30) lie.

46. Laser amplifier system according to any of the preceding claims,
**characterized in that**
the solid body (10) is embodied as antireflective for the laser amplifier radiation field (20) on a side of the laser-active volume region (24).

47. Laser amplifier system according to the preceding claim,
**characterized in that**
the solid body (10) is provided with an antireflective volume region (48) on a side of the laser-active volume region (24).

48. Laser amplifier system according to Claim 46 or 47, **characterized in that**
the antireflective volume region (48) and the volume region (38) forming the reflector (40, 80) are arranged on different sides of the laser-active volume region (24) in the stacking direction (28).

49. Laser amplifier system according to any of the preceding claims,
**characterized in that**
the solid body (10) is embodied as antireflective on an entrance side of the pump radiation field (70).

50. Laser amplifier system according to the preceding claim,
**characterized in that**
the solid body (10) is provided with an antireflective volume region (48).

51. Laser amplifier system according to Claim 49 or 50,
**characterized in that**
the solid body (10) is embodied as antireflective for the pump radiation field (70) on a side of the laser-active volume region (24).

52. Laser amplifier system according to the preceding claim,
**characterized in that**
the antireflective volume region (48) and the volume region (38) forming the reflector (80) are arranged on different sides of the laser-active volume region (24) in the stacking direction (28).

53. Laser amplifier system according to any of the preceding claims,
**characterized in that**
the pump radiation field (70') enters the solid body (10) via a side area (120).

54. Laser amplifier system according to the preceding claim,
**characterized in that**
the pump radiation field (70') enters the solid body (10) divergently and is guided therein by reflections in a direction transversely with respect to the optical axis (22) of the laser amplifier radiation field (20).

55. Laser amplifier system according to the preceding claim,
**characterized in that**
the reflections of the pump radiation field (70') are effected by refractive index gradients and/or refractive index steps in the solid body (10).

56. Laser amplifier system according to any of the preceding claims,
**characterized in that**
the laser amplifier radiation field (20) is defined by an amplifier optical unit (60) comprising at least one external mirror (62) arranged at a distance from the solid body (10).

57. Laser amplifier system according to any of the preceding claims,
**characterized in that**
the amplifier optical unit (60) is embodied such that it permits only a laser radiation field (20) having the fundamental mode or having the fundamental mode and modes near the fundamental mode.

## Revendications

1. Système d'amplification laser comprenant
un corps solide (10) couplé thermiquement à un corps de refroidissement (16) et doté d'une partie (24) de volume à activité laser dans au moins une surface (26) de laquelle est disposée une structure quantique (30) à activité laser en matériau semi-conducteur, qui s'étend au moins sur certaines parties de la surface,
une source (72) de rayonnement de pompage qui forme un champ (70) de rayonnement de pompage pour pomper optiquement la partie (24) à activité laser du volume et
une optique d'amplification (60) qui définit un champ (20) de rayonnement d'amplification laser qui traverse la partie (24) à activité laser du volume,
**caractérisé en ce que**
la partie (24) à activité laser du volume présente plusieurs structures quantiques (30) disposées à distance mutuelle dans une direction d'empilement (28) mais situées dans des surfaces (26) disposées les unes au-dessus des autres,
**en ce que** les structures quantiques (30) sont séparées les unes des autres par des couches intermédiaires (34) situées entre elles, les couches intermédiaires étant constituées exclusivement d'une structure environnante,
**en ce que** l'absorption du rayonnement laser provenant du champ (70) de rayonnement laser dans la structure quantique (30) à activité laser est supérieure à l'absorption du rayonnement de pompage par la structure environnante adjacente à la structure quantique (30) et
**en ce que** l'absorption du rayonnement de pompage provenant du champ (70) de rayonnement de pompage dans les structures quantiques (30) est supérieure à l'absorption du rayonnement de pompage par les couches intermédiaires (34), de telle sorte que le rayonnement de pompage est auto-absorbé principalement dans les structures quantiques (30),
**en ce que** le champ (70) de rayonnement de pompage s'étend de telle sorte qu'il traverse plusieurs fois la structure quantique (30),
**en ce que** dans chaque surface (26), plusieurs structures quantiques (30₁ à 30_{N}) sont prévues les unes à côté des autres,
**en ce que** les structures quantiques (30₁ à 30_{N}) disposées à la suite les unes des autres sont séparées optiquement les unes des autres dans la direction transversale à la direction (28) d'empilement,
**en ce que** les structures quantiques (30₁ à 30_{N}) sont séparées les unes des autres par des barrières (114) en matériaux optiquement absorbants, les matériaux absorbants absorbant principalement de la plage de longueur d'onde du champ de rayonnement d'amplification laser des structures quantiques et
**en ce que** le champ (70) de rayonnement de pompage ne traverse simultanément pas des parties contiguës (100) de la surface (26) dans lequel sont disposées les structures quantiques (30₁ à 30_{N}) et pompent optiquement les structures quantiques (30₁ à 30_{N}) prévues à l'intérieur de ces parties (100) de la surface.

2. Système d'amplification laser selon la revendication précédente, **caractérisé en ce que** l'absorption du rayonnement de pompage dans la ou les structures quantiques (30) dépasse l'absorption du rayonnement de pompage dans les parties de volume du corps solide (10) situé à l'extérieur de la structure quantique (30).

3. Système d'amplification laser selon l'une des revendications précédentes, **caractérisé en ce que** la structure environnante est formée d'un matériau semi-conducteur.

4. Système d'amplification laser selon la revendication précédente, **caractérisé en ce que** la structure environnante est formée de couches de matériau semi-conducteur.

5. Système d'amplification laser selon les revendications 3 ou 4, **caractérisé en ce que** le matériau semi-conducteur de la structure quantique (30) présente un écart de bande plus petit que la structure environnante.

6. Système d'amplification laser selon l'une des revendications précédentes, **caractérisé en ce que** chaque structure environnante présente transversalement à la surface (26) une épaisseur qui correspond à un multiple de l'épaisseur de la structure quantique (30).

7. Système d'amplification laser selon l'une des revendications précédentes, **caractérisé en ce que** la structure environnante présente transversalement à la surface (26) une épaisseur qui vaut au moins 10 nm.

8. Système d'amplification laser selon la revendication précédente, **caractérisé en ce que** la structure environnante présente transversalement à la surface (26) une épaisseur qui vaut au moins 30 nm.

9. Système d'amplification laser selon l'une des revendications précédentes, **caractérisé en ce que** le champ (20) de rayonnement d'amplification laser s'étend transversalement à la surface (26) dans laquelle s'étend la structure quantique (30).

10. Système d'amplification laser selon l'une des revendications précédentes, **caractérisé en ce que** le champ (20) de rayonnement d'amplification laser s'étend sensiblement dans la direction de l'empilement (28) à travers les structures quantiques (30).

11. Système d'amplification laser selon la revendication précédente, **caractérisé en ce que** pour au moins une partie des structures quantiques (30), ces dernières présentent dans la direction d'empilement (28) des écarts (A) qui correspondent sensiblement à la moitié de la longueur d'onde ou à un multiple entier de la moitié de la longueur d'onde du champ (20) de rayonnement d'amplification laser lors d'une amplification laser optimale.

12. Système d'amplification laser selon la revendication précédente, **caractérisé en ce que** les écarts (A) des structures quantiques (30) correspondent dans un état d'équilibre thermodynamique à l'amplification laser de la partie (24) à activité laser du volume sensiblement à la moitié de la longueur d'onde ou au multiple entier de la moitié de la longueur d'onde de l'amplification laser optimale.

13. Système d'amplification laser selon l'une des revendications précédentes, **caractérisé en ce que** la surface (26) dans laquelle la structure quantique (30) est disposée s'étend sensiblement en parallèle à une surface extérieure de refroidissement (12) du corps solide.

14. Système d'amplification laser selon l'une des revendications précédentes, **caractérisé en ce que** la surface (26) dans laquelle la structure quantique (30) est disposée s'étend sensiblement en parallèle à une surface de sortie (50) du champ (20) de rayonnement d'amplification laser.

15. Système d'amplification laser selon la revendication précédente, **caractérisé en ce qu'**une couche optiquement inactive (34) dont l'épaisseur représente un multiple de la longueur d'onde du champ de rayonnement d'amplification laser s'étend entre la surface de sortie (50) du champ (20) de rayonnement d'amplification laser et la surface (26) dans laquelle la structure quantique (30) s'étend.

16. Système d'amplification laser selon l'une des revendications précédentes, **caractérisé en ce que** la structure quantique (30) présente une épaisseur suffisamment faible pour permettre un renforcement de la densité d'état sur les bords de la bande.

17. Système d'amplification laser selon l'une des revendications précédentes, **caractérisé en ce que** la structure quantique (30) présente une épaisseur qui est sensiblement de l'ordre de grandeur de la longueur d'onde des électrons dans le matériau de la structure quantique.

18. Système d'amplification laser selon l'une des revendications précédentes, **caractérisé en ce que** la structure quantique (30) présente transversalement à la surface (26) une épaisseur d'au moins 20 nm.

19. Système d'amplification laser selon l'une des revendications précédentes, **caractérisé en ce que** la structure quantique (30) est configurée comme film quantique.

20. Système d'amplification laser selon l'une des revendications précédentes, **caractérisé en ce que** la structure quantique (30) est formée de fil quantique.

21. Système d'amplification laser selon l'une des revendications précédentes, **caractérisé en ce que** la structure quantique (30) est formée de points quantiques.

22. Système d'amplification laser selon l'une des revendications précédentes, **caractérisé en ce que** le corps solide (10) présente sur une face de la partie (24) à activité laser du volume un réflecteur (40) pour le champ (20) de rayonnement d'amplification laser.

23. Système d'amplification laser selon la revendication précédente, **caractérisé en ce que** le réflecteur (40) est un réflecteur interne disposé dans le corps solide (10).

24. Système d'amplification laser selon la revendication précédente, **caractérisé en ce que** le réflecteur interne (40) est formé d'une succession de couches (42).

25. Système d'amplification laser selon les revendications 23 ou 24, **caractérisé en ce que** le corps solide (10) est doté sur une face de la partie (24) à activité laser du volume d'une partie réfléchissante (38) de volume qui forme le réflecteur interne (40).

26. Système d'amplification laser selon la revendication précédente, **caractérisé en ce que** la partie réfléchissante du volume présente une partie configurée comme réflecteur de Bragg (40).

27. Système d'amplification laser selon l'une des revendications 22 à 26, **caractérisé en ce que** le réflecteur interne (40, 80) est disposé à une distance de la surface de refroidissement (12) qui représente moins de 100 µm.

28. Système d'amplification laser selon l'une des revendications précédentes, **caractérisé en ce que** le champ (70) de rayonnement de pompage traverse plusieurs fois la partie (24) à activité laser du volume dans une direction qui s'étend transversalement par rapport à la surface (26) dans laquelle s'étend la structure quantique (30).

29. Système d'amplification laser selon la revendication précédente, **caractérisé en ce que** le champ (70) de rayonnement de pompage traverse la même surface supérieure (50) du corps solide (10) que le champ de rayonnement d'amplification laser.

30. Système d'amplification laser selon la revendication précédente, **caractérisé en ce que** la surface (50) est disposée face à la surface de refroidissement (14).

31. Système d'amplification laser selon l'une des revendications précédentes, **caractérisé en ce que** la surface (26) dans laquelle la structure quantique (30) est disposée s'étend sensiblement en parallèle à une surface (50) du corps solide (10) traversé par le champ (70) de rayonnement de pompage.

32. Système d'amplification laser selon l'une des revendications précédentes, **caractérisé en ce que** sur un côté de la partie (24) à activité laser du volume, le corps solide (10) est doté d'un réflecteur (80) pour le champ (70) de rayonnement de pompage.

33. Système d'amplification laser selon la revendication précédente, **caractérisé en ce que** le réflecteur (80) est un réflecteur (80) disposé dans le corps solide (10).

34. Système d'amplification laser selon la revendication précédente, **caractérisé en ce que** le réflecteur interne (80) est formé d'une succession de couches (42).

35. Système d'amplification laser selon les revendications 33 ou 34, **caractérisé en ce que** le réflecteur interne (80) prévu pour le champ (70) de rayonnement de pompage est formé par une partie réfléchissante (38) du volume.

36. Système d'amplification laser selon la revendication précédente, **caractérisé en ce que** la partie réfléchissante (38) du volume comporte une partie configurée comme réflecteur de Bragg.

37. Système d'amplification laser selon l'une des revendications 22 à 36, **caractérisé en ce que** le réflecteur (40) prévu pour le champ (20) de rayonnement d'amplification laser et le réflecteur (80) de champ (70) de rayonnement de pompage sont rassemblés en un réflecteur (40).

38. Système d'amplification laser selon la revendication précédente, **caractérisé en ce que** le réflecteur (40) est formé d'une succession de couches (42) dont la structure et l'agencement sont optimisés en termes de longueur d'onde et d'angle d'incidence du champ (20) de rayonnement d'amplification laser et de la longueur d'onde et de l'angle d'incidence du champ (70) de rayonnement de pompage.

39. Système d'amplification laser selon l'une des revendications précédentes, **caractérisé en ce que** la structure quantique (30) présente transversalement à la direction (28) d'empilement une extension plus petite que celle du corps solide (10) dans cette direction.

40. Système d'amplification laser selon l'une des revendications précédentes, **caractérisé en ce que** dans chaque surface (26), une structure quantique (30) est prévue.

41. Système d'amplification laser selon l'une des revendications précédentes, **caractérisé en ce que** le champ (70) de rayonnement de pompage traverse la surface (26) dans laquelle s'étend chaque structure quantique (30) dans une partie (88a, b) de surface plus petite que l'extension de la structure quantique (30) dans la direction de la surface (26).

42. Système d'amplification laser selon la revendication précédente, **caractérisé en ce que** le champ (70) de rayonnement de pompage traverse une partie de surface (88a, 88b) lors de chaque traversée de la surface (26) dans laquelle la structure quantique (30) est disposée et **en ce que** la somme des parties de surface (88a, b) forme une partie continue d'excitation (88).

43. Système d'amplification laser selon la revendication précédente, **caractérisé en ce que** le champ (70) de rayonnement pompage présente des segments non contigus (70'a à d) de champ de rayonnement de pompage dont chacun traverse au moins une des parties de surface (100).

44. Système d'amplification laser selon la revendication précédente, **caractérisé en ce que** les structures quantiques (30₁ à 30_{N}) sont entourées par les barrières (114) en matériaux optiquement absorbants.

45. Système d'amplification laser selon l'une des revendications précédentes, **caractérisé en ce que** les barrières (114) en matériaux optiquement absorbants forment une structure fermée dans les surfaces (26) dans lesquelles sont situées les structures quantiques (30).

46. Système d'amplification laser selon l'une des revendications précédentes, **caractérisé en ce que** le corps solide (10) est antiréfléchissant pour le champ (20) de rayonnement d'amplification laser sur un côté de la partie (24) à activité laser du volume.

47. Système d'amplification laser selon l'une des revendications précédentes, **caractérisé en ce que** le corps solide (10) est doté d'une partie antiréfléchissante (48) de volume sur un côté de la partie (24) à activité laser du volume.

48. Système d'amplification laser selon les revendications 46 ou 47, **caractérisé en ce que** la partie antiréfléchissante (48) du volume et la partie (38) du volume qui forme le réflecteur (40, 80) sont disposées sur des côtés différents de la partie (24) à activité laser du volume dans la direction d'empilement (28).

49. Système d'amplification laser selon l'une des revendications précédentes, **caractérisé en ce que** le corps solide (10) est antiréfléchissant sur le côté d'entrée du champ (70) de rayonnement de pompage.

50. Système d'amplification laser selon la revendication précédente, **caractérisé en ce que** le corps solide (10) est doté d'une partie antiréfléchissante (48) de volume.

51. Système d'amplification laser selon les revendications 49 ou 50, **caractérisé en ce que** le corps solide (10) est antiréfléchissant pour le champ (70) de rayonnement de pompage sur un côté de la partie (24) à activité laser du volume.

52. Système d'amplification laser selon la revendication précédente, **caractérisé en ce que** la partie antiréfléchissante (48) du volume et la partie (38) du volume qui forme le réflecteur (80) sont disposées sur des côtés de la partie (24) à activité laser du volume différent dans la direction d'empilement (28).

53. Système d'amplification laser selon l'une des revendications précédentes, **caractérisé en ce que** le champ (70') de rayonnement de pompage pénètre dans le corps solide (10) par une surface latérale (120).

54. Système d'amplification laser selon la revendication précédente, **caractérisé en ce que** le champ (70') de rayonnement de pompage pénètre de manière divergente dans le corps solide (10) et est guidé dans ce dernier par des réflexions dans une direction transversale à l'axe optique (22) du champ (20) de rayonnement d'amplification laser.

55. Système d'amplification laser selon la revendication précédente, **caractérisé en ce que** les réflexions du champ (70') de rayonnement de pompage s'effectuent par gradients d'indice de réfraction et/ou par gradins d'indice de réfraction dans le corps solide (10).

56. Système d'amplification laser selon l'une des revendications précédentes, **caractérisé en ce que** le champ (20) de rayonnement d'amplification laser est défini par une optique d'amplification (60) qui comporte au moins un miroir externe (62) disposé à distance du corps solide (10).

57. Système d'amplification laser selon l'une des revendications précédentes, **caractérisé en ce que** l'optique d'amplification (60) est configurée de telle sorte qu'elle ne permet qu'un seul champ (20) de rayonnement laser en mode de base ou en mode de base et en mode proche du mode de base.
